# EUROPEAN PATENT SPECIFICATION

(11) **EP 3 565 013 B1**
(45) Date of publication and mention of the grant of the patent: **23.04.2025**
(21) Application number: 17887322.0
(22) Date of filing: 21.11.2017
(51) Int. Cl.: H01M 10/04, H01M 10/0585, H01M 50/103, H01M 50/124, H01M 50/209, H01M 50/50, H01M 50/54, H01M 50/557, H10N 99/00, H01M 50/503

(54) **LAMINATED BATTERY**
LAMINIERTE BATTERIE
BATTERIE STRATIFIÉE

(30) Priority: 27.12.2016 JP 2016252630
(43) Date of publication of application: 06.11.2019
(73) Proprietor: Kabushiki Kaisha Nihon Micronics, Musashino-shi, Tokyo 180-8508 (JP)
(72) Inventor: SANO, Masami, Musashino-shi Tokyo 180-8508 (JP); UEKI, Isao, Musashino-shi Tokyo 180-8508 (JP); IGARASHI, Masayuki, Musashino-shi Tokyo 180-8508 (JP)
(74) Representative: Opilex
(86) International application number: PCT/JP2017/041755
(87) International publication number: WO 2018/123353

(56) References cited:
- EP-A1- 1 734 597
- EP-A1- 2 838 148
- EP-A1- 3 401 979
- JP-A- 2008 066 170
- JP-A- 2008 293 717
- JP-A- 2012 138 368
- JP-A- 2014 038 817
- JP-A- 2016 .09 .01
- JP-A- 2016 157 670

## Description

### Technical Field

The present invention relates to a technique in which a plurality of sheet batteries are laminated together.

### Background Art

Patent Literature 1 discloses a connection structure between an electrode tab and a tab lead in a capacitor such as a lithium-ion battery. Patent Literature 2 discloses a nonaqueous solid-electrolyte battery in which a tab lead is connected to a positive electrode and a negative electrode. In Patent Literature 1 and 2, a positive electrode tab and a negative electrode tab are arranged in a staggered fashion when viewed from above. Document EP2838148A1 discloses a secondary battery which is small in size and in which current capacity per unit volume can be increased. The secondary battery includes two cell units each including a charging layer between a first electrode layer and a second electrode layer, the two cell units being parallel-connected by juxtaposing and connecting a first electrode layer of one cell unit and a first electrode layer of the other cell unit or a second electrode layer of the one cell unit and a second electrode layer of the other cell unit, and by wire-connecting the second electrode layer of the one cell unit and the second electrode layer of the other cell unit or the first electrode layer of the one cell unit and the first electrode layer of the other cell unit.

### Citation List

### Patent Literature

PTL1: Japanese Unexamined Patent Application Publication No. 2014-38817
PTL2: Japanese Unexamined Patent Application Publication No. 2011-81925

### Summary of Invention

### Technical Problem

For a high-capacity battery, a laminated structure where sheet batteries are laminated together is employed. In this case, if tabs overlap each other, the thickness of the battery increases. To be specific, the thickness of the laminated structure increases because the thickness of a lamination of two sheets is the total thickness of sheets, tab leads, an insulating material, a conductive bonding agent and the like.

Further, if the positions of tab leads are staggered to reduce the thickness, a step of joining tab leads is needed, which decreases productivity. Further, if tab leads are comb-shaped or the like, a step of lamination becomes complicated, which also decreases productivity.

The present invention has been accomplished to solve the above problems and an object of the present invention is thus to provide a technique to simplify the structure of a laminated battery.

### Solution to Problem

A laminated battery according to one aspect of this embodiment is a secondary battery in which a plurality of sheet batteries are laminated, which includes a first sheet battery, a second sheet battery, a third sheet battery and a fourth sheet battery, each including a first electrode on a front side surface and a second electrode on a back side surface, in which when viewed from above in a state where the first sheet battery, the second sheet battery, the third sheet battery and the fourth sheet battery are laminated, the first sheet battery includes a first tab part placed so as to project outward of the second sheet battery, and the second sheet battery includes a second tab part placed so as to project outward of the first sheet battery in a state where the second electrode of the first sheet battery and the second electrode of the second sheet battery are placed face-to-face to each other, the third sheet battery includes a third tab part placed so as to project outward of the fourth sheet battery, and the fourth sheet battery includes a fourth tab part placed so as to project outward of the third sheet battery in a state where the second electrode of the third sheet battery and the second electrode of the fourth sheet battery are placed face-to-face to each other, and the first tab part and the fourth tab part overlap each other so that the second electrode on the surface of the first tab part and the second electrode on the surface of the fourth tab part are placed face-to-face to each other.

In the above-described laminated battery, the second electrode on the surface of the first tab part and the second electrode on the surface of the fourth tab part may be connected through a conductive bonding agent.

In the above-described laminated battery, a thickness of the conductive bonding agent may be equal to a total thickness of the second sheet battery and the third sheet battery.

In the above-described laminated battery, the first to fourth sheet batteries may be laminated and folded without folding the first tab part, the second tab part, the third tab part and the fourth tab part.

In the above-described laminated battery, each of the first sheet battery, the second sheet battery, the third sheet battery and the fourth sheet battery may include a base material serving as the first electrode, and peripheral parts of the base materials of the first sheet battery, the second sheet battery, the third sheet battery and the fourth sheet battery may be bonded together.

In the above-described laminated battery, the second tab part and the third tab part are placed so as to overlap each other when viewed from above in a state where the first to fourth sheet batteries are laminated.

In the above-described laminated battery, the laminated battery may further include a fifth sheet battery and a sixth sheet battery, each including a first electrode on a front side surface and a second electrode on a back side surface, wherein when viewed from above in a state where the first to sixth sheet batteries are laminated, the fifth sheet battery may include a fifth tab part placed so as to project outward of the sixth sheet battery, and the sixth sheet battery may include a sixth tab part placed so as to project outward of the fifth sheet battery in a state where the second electrode of the fifth sheet battery and the second electrode of the sixth sheet battery are placed face-to-face to each other, and the third tab part and the sixth tab part may overlap each other so that the second electrode on the surface of the third tab part and the second electrode on the surface of the sixth tab part are placed face-to-face to each other and connected.

In the above-described laminated battery, the second electrode on the surface of the third tab part and the second electrode on the surface of the sixth tab part may be connected through a conductive bonding agent.

In the above-described laminated battery, the first electrode of the second sheet battery and the first electrode of the third sheet battery may be placed face-to-face to each other and connected.

In the above-described laminated battery, a first insulating material may be formed on the first sheet battery, a second insulating material may be formed on the second sheet battery, a third insulating material may be formed on the third sheet battery, a fourth insulating material may be formed on the fourth sheet battery, the first insulating material may be formed in close proximity to the second tab part, the second insulating material may be formed in close proximity to the first tab part, the third insulating material may be formed in close proximity to the fourth tab part, and the fourth insulating material may be formed in close proximity to the third tab part.

In the above-described laminated battery, the first to fourth sheet batteries may include rectangular parts placed so as to overlap each other when viewed from above in a state where the first to fourth sheet batteries are laminated, the first to fourth tab parts may project outward from one side of the rectangular parts.

In the above-described laminated battery, the first to fourth sheet batteries may include rectangular parts placed so as to overlap each other when viewed from above in a state where the first to fourth sheet batteries are laminated, the first tab part and the fourth tab part may project outward from a first side of the rectangular parts, and the second tab part and the third tab part may project outward from a second side opposed to the first side.

In the above-described laminated battery, each of the first to fourth sheet batteries may include a base material serving as the first electrode, the second electrode may be formed on both surfaces of the base material, and the second electrode of the second sheet battery and the second electrode of the third sheet battery may be placed face-to-face to each other and connected.

### Advantageous Effects of Invention

According to the present invention, it is possible to provide a technique to simplify the structure of a laminated battery.

### Brief Description of Drawings

Fig. 1 is a cross-sectional view showing the structure of a sheet battery.
Fig. 2 is an X-Y plane view showing the structure of type-I and type-II sheet batteries.
Fig. 3 is an exploded perspective view showing the structure of a sheet pair using the type-I sheet battery.
Fig. 4 is an X-Z plane view showing the side structure of the sheet pair using the type-I sheet battery.
Fig. 5 is an X-Y plane view showing the planar shape of the sheet pair using the type-I sheet battery.
Fig. 6 is an X-Y plane view showing the planar shape of a sheet pair using the type-II sheet battery.
Fig. 7 is a schematic view showing the structure of a laminated battery according to a first embodiment.
Fig. 8 is an X-Z plane view showing the side structure of the laminated battery according to the first embodiment.
Fig. 9 is an X-Y plane view illustrating a fold line of the laminated battery according to the first embodiment.
Fig. 10 is an X-Y plane view showing the structure of a type-III sheet battery.
Fig. 11 is an exploded perspective view showing the structure of a sheet pair using the type-III sheet battery.
Fig. 12 is an X-Z plane view showing the side structure of the sheet pair using the type-III sheet battery.
Fig. 13 is an X-Y plane view showing the planar shape of the sheet pair using the type-III sheet battery.
Fig. 14 is an X-Y plane view showing the planar shape of another sheet pair using the type-III sheet battery.
Fig. 15 is an X-Z plane view showing the side structure of a laminated battery according to a second embodiment.
Fig. 16 is an X-Y plane view illustrating a fold line of the laminated battery according to the second embodiment.
Fig. 17 is a cross-sectional view showing the structure of a sheet battery.
Fig. 18 is an X-Y plane view showing the structure of type-IV and type-V sheet batteries.
Fig. 19 is an X-Z plane view showing the side structure of a sheet pair using the type-IV sheet battery.
Fig. 20 is an X-Y plane view showing the planar shape of the sheet pair using the type-IV sheet battery.
Fig. 21 is a schematic view showing the structure of a laminated battery according to a third embodiment.
Fig. 22 is a plan view showing a modified example where the position of an insulating material is different.
Fig. 23 is an exploded perspective view showing a sheet pair using the sheet battery of the modified example.

### Description of Embodiments

Examples of embodiments of the present invention are described hereinafter with reference to the drawings. The following description describes preferred embodiments of the present invention, and the technical scope of the present invention is not limited to the embodiments described below. The invention is defined by the appended claims.

### First Embodiment

### (Laminated Structure of Sheet Battery)

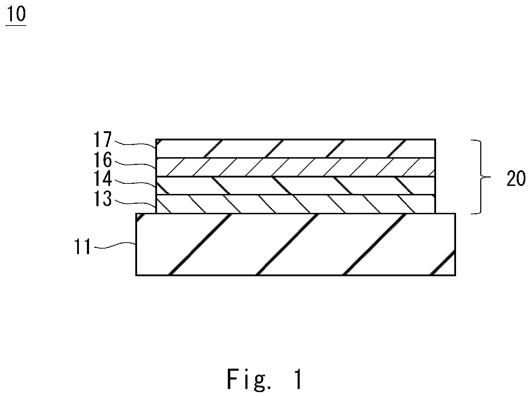

Fig. 1 is a view showing the cross-sectional structure of a sheet battery 10, which is a sheet-shaped oxide semiconductor secondary battery.

In Fig. 1, the sheet battery 10 has a laminated structure in which an n-type oxide semiconductor layer 13, a charging layer 14, a p-type oxide semiconductor layer 16, and a second electrode 17 are laminated in this order on a base material 11. Note that the laminated structure formed on the base material 11 is a laminate 20. Thus, the laminate 20 includes the n-type oxide semiconductor layer 13, the charging layer 14, the p-type oxide semiconductor layer 16, and the second electrode 17.

The base material 11 is made of a conductive material such as metal or the like, and it functions as a first electrode. In this embodiment, the base material 11 acts as a negative electrode. For example, a metallic foil sheet such as an SUS sheet or an aluminum sheet may be used as the base material 11.

Alternatively, the base material 11 made of an insulating material may be prepared, and the first electrode may be formed on the base material 11. The base material 11 may have any structure as long as it includes the first electrode. In the case of forming the first electrode on the base material 11, a metallic material such as chromium (Cr) or titanium (Ti) may be used as a material of the first electrode. An ally film containing aluminum (Al), silver (Ag) or the like may be used as a material of the first electrode. When forming the first electrode on the base material 11, it can be formed in the same manner as that by which the second electrode 17 is formed, which is described later.

The n-type oxide semiconductor layer 13 is formed on the base material 11. The n-type oxide semiconductor layer 13 is formed so as to contain an n-type oxide semiconductor material (a second n-type oxide semiconductor material). For example, titanium dioxide (TiO₂), tin oxide (SnO₂), zinc oxide (ZnO) or the like can be used as the n-type oxide semiconductor layer 13. The n-type oxide semiconductor layer 13 may be deposited on the base material 11 by, for example, sputtering or vapor deposition. It is preferred to use titanium dioxide (TiO₂) as a material of the n-type oxide semiconductor layer 13.

The charging layer 14 is formed on the n-type oxide semiconductor layer 13. The charging layer 14 is made of a mixture of an insulating material and an n-type oxide semiconductor material. For example, as an n-type oxide semiconductor material (a first n-type oxide semiconductor material) of the charging layer 14, fine particles of n-type oxide semiconductor may be used. The photoexcited structure of the n-type oxide semiconductor is changed by exposure to ultraviolet radiation and becomes a layer with a charging function. Silicone resin may be used as an insulating material of the charging layer 14. For example, it is preferred to use a silicon compound (silicone) with a basic skeleton having a siloxane bond of silicon oxide or the like as an insulating material.

For example, the charging layer 14 is made of oxide silicon and titanium dioxide where the first n-type oxide semiconductor material is titanium dioxide. Other preferred n-type oxide semiconductor materials that can be used for the charging layer 14 are tin oxide (SnO₂) and zinc oxide (ZnO). A material composed of a combination of two or all of titanium dioxide, tin oxide and zinc oxide may be used.

A fabrication process of the charging layer 14 is described hereinafter. First, a coating liquid made by mixing a solvent with a mixture of a precursor of titanium oxide, tin oxide or zinc oxide and silicone oil is prepared. Further, a coating liquid made by mixing fatty acid titanium and silicone oil with a solvent is prepared. Then, the coating liquid is applied over the n-type oxide semiconductor layer 13 by spin coating, slit coating or the like. The coating film is then dried and baked, thereby forming the charging layer 14 on the n-type oxide semiconductor layer 13. Note that an example of a precursor is titanium stearate, which is a precursor of titanium oxide. Titanium oxide, tin oxide and zinc oxide are formed by being resolved from aliphatic acid chloride, which is a precursor of metallic oxide. The charging layer 14 after drying and baking may be exposed to ultraviolet radiation so that it is UV cured.

Note that, for titanium oxide, tin oxide, zinc oxide and the like, fine particles of an oxide semiconductor may be used instead of using a precursor. A mixed solution is made by mixing nanoparticles of titanium oxide or zinc oxide with silicone oil. Further, a coating liquid is made by mixing a solvent with the mixed solution. The coating liquid is applied over the n-type oxide semiconductor layer 13 by spin coating, slit coating or the like. The coating film is then dried, baked and UV-exposed, thereby forming the charging layer 14.

The first n-type oxide semiconductor material contained in the charging layer 14 and the second n-type oxide semiconductor material contained in the n-type oxide semiconductor layer 13 may be the same or different. For example, when the n-type oxide semiconductor material contained in the n-type oxide semiconductor layer 13 is tin oxide, the n-type oxide semiconductor material in the charging layer 14 may be tin oxide or an n-type oxide semiconductor material other than tin oxide.

The p-type oxide semiconductor layer 16 is formed on the charging layer 14. The p-type oxide semiconductor layer 16 is formed so as to contain a p-type oxide semiconductor material. Nickel oxide (NiO), copper aluminum oxide (CuAlO₂) or the like can be used as a material of the p-type oxide semiconductor layer 16. For example, the p-type oxide semiconductor layer 16 may be a nickel oxide layer with a thickness of 400 nm. The p-type oxide semiconductor layer 16 is deposited on the charging layer 14 by a deposition method such as vapor deposition or sputtering.

The second electrode 17 may be formed using a conductive film. A metallic material such as chromium (Cr) or copper (Cu) may be used as a material of the second electrode 17. Another example of a metallic material is a silver (Ag) alloy containing aluminum (Al) or the like. A method of formation may be a vapor-phase deposition such as sputtering, ion plating, electron beam evaporation, vacuum deposition or chemical vapor deposition. Further, a metallic electrode may be formed by electroplating, electroless plating or the like. A metal that is used for plating is typically copper, copper alloy, nickel, aluminum, silver, gold, zinc, tin or the like. For example, the second electrode 17 is an Al film with a thickness of 300 nm.

Although the n-type oxide semiconductor layer 13 is placed under the charging layer 14, and the p-type oxide semiconductor layer 16 is placed on top of the charging layer 14 in the above description, the positions of the n-type oxide semiconductor layer 13 and the p-type oxide semiconductor layer 16 may be interchanged. Specifically, the n-type oxide semiconductor layer 13 may be placed on top of the charging layer 14, and the p-type oxide semiconductor layer 16 may be placed under the charging layer 14. In this case, the base material 11 acts as a positive electrode, and the second electrode 17 acts as a negative electrode. Thus, on top of the charging layer 14 may be any of the n-type oxide semiconductor layer 13 and the p-type oxide semiconductor layer 16 as long as the charging layer 14 is interposed between the n-type oxide semiconductor layer 13 and the p-type oxide semiconductor layer 16. In other words, the sheet battery 10 has a structure where the first electrode (the base material 11), the first conductivity type oxide semiconductor layer (the n-type oxide semiconductor layer 13 or the p-type oxide semiconductor layer 16), the charging layer 14, the second conductivity type oxide semiconductor layer (the p-type oxide semiconductor layer 16 or the n-type oxide semiconductor layer 13), and the second electrode 17 are laminated in this order from the bottom.

Further, the sheet battery 10 may have a structure that includes a layer other than the first electrode (the base material 11), the first conductivity type oxide semiconductor layer (the n-type oxide semiconductor layer 13 or the p-type oxide semiconductor layer 16), the charging layer 14, the second conductivity type oxide semiconductor layer (the p-type oxide semiconductor layer 16 or the n-type oxide semiconductor layer 13), and the second electrode 17.

As described above, the laminate 20 that includes the n-type oxide semiconductor layer 13, the charging layer 14, the p-type oxide semiconductor layer 16 and the second electrode 17 is placed on top of the base material 11. Thus, the uppermost surface of the sheet battery 10 is the second electrode 17. Note that the laminate 20 is not at the edge of the sheet battery 10. The laminate 20 is formed substantially all over the base material 11 except for the edge of its surface. Thus, the base material 11 is exposed to the outside at the edge of the sheet battery 10. In other words, the outside of the laminate 20 (i.e., the periphery of the base material 11) is an exposure position where the base material 11 is exposed to the outside. The base material 11 is the uppermost surface of the sheet battery 10 on the periphery of the sheet battery 10.

The secondary battery according to this embodiment has a structure where the sheet batteries 10 shown in Fig. 1 are laminated together, thus having a high capacity. To be specific, a plurality of sheet batteries 10 are connected in parallel, thereby increasing the capacity of the secondary battery. To this end, the sheet batteries 10 are laminated face-to-face in this embodiment.

### (Planar Shape of Sheet Battery)

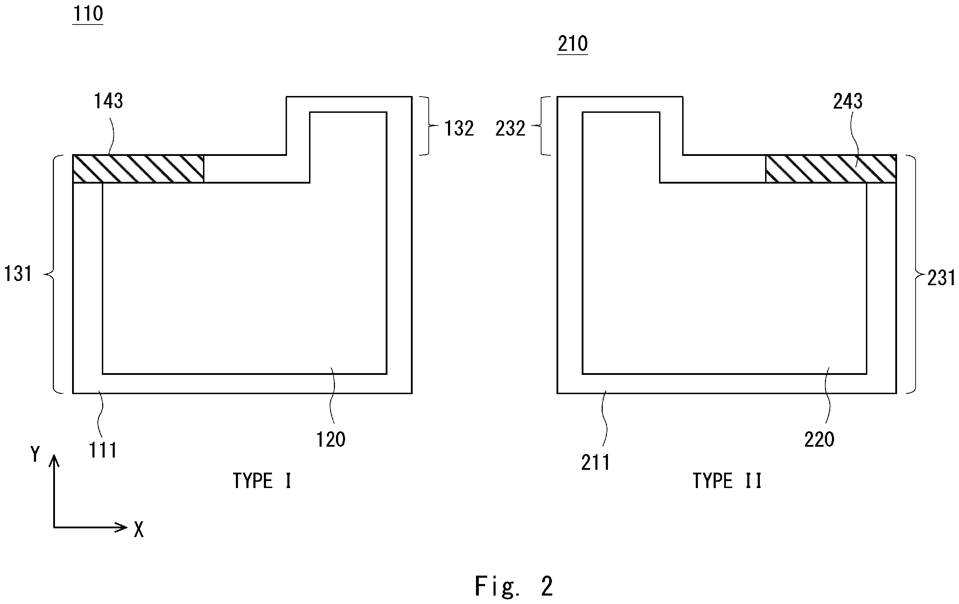

In this embodiment, two types of sheet batteries are prepared. The two types of sheet batteries are the same in laminated structure and different in planar shape. Fig. 2 shows the planar shapes of two types of sheet batteries. In Fig. 2, one of the two types of sheet batteries is type-I sheet battery 110, and the other is type-II sheet battery 210. In Fig, 2, a plane on which the sheet batteries 110 and 210 are placed is an X-Y plane. The X direction and the Y direction are orthogonal to each other. Further, Fig. 2 shows the planar shapes of the sheet batteries 110 and 210 when viewed from the laminate 20 side (the upper side of Fig. 1).

The planar shape of the type-I sheet battery 110 on the X-Y plane is described first. As shown in Fig. 2, the sheet battery 110 has a rectangular part 131 and a tab part 132. The rectangular part 131 may be oblong or square on the X-Y plane. In this example, the rectangular part 131 has an oblong shape having sides parallel to the X direction and the Y direction, with their longer sides along the X direction. The tab part 132 juts out in the +Y direction from the rectangular part 131. Specifically, the tab part 132 projects outward from one side along the X direction of the rectangular part 131. In this example, the sheet battery 110 is inverted L-shaped on the X-Y plane. The tab part 132 is formed at the +X and +Y side edge of the rectangular part 131.

A base material 111 in Fig. 2 corresponds to the base material 11 in Fig. 1. Likewise, a laminate 120 in Fig. 2 corresponds to the laminate 20 in Fig. 1. Thus, the laminate 120 includes the n-type oxide semiconductor layer 13, the charging layer 14, the p-type oxide semiconductor layer 16 and the second electrode 17 as shown in Fig. 1.

A major part of the laminate 120 is formed in the rectangular part 131 and the tab part 132. Thus, the uppermost surface is the second electrode 17 in the most part of the rectangular part 131 and the tab part 132. In the area where the laminate 120 is not placed, the base material 111 is exposed to the outside. Therefore, the uppermost surface is the base material 111 in the peripheral part of the sheet battery 110.

Further, an insulating material 143 is formed on the sheet battery 110. As shown in Fig. 2, the insulating material 143 is formed as a part of the rectangular part 131. To be specific, the tab part 132 is formed at the +X and +Y side edge of the rectangular part 131, and the insulating material 143 is formed at the -X and +Y side edge of the rectangular part 131. The insulating material 143 is placed along the X direction.

The insulating material 143 is placed on the outside of the laminate 120. Specifically, the insulating material 143 is formed in the area where the uppermost surface is the base material 111. The insulating material 143 is formed directly on the base material 111 so as to be in contact with the base material 111. The insulating material 143 is formed to cover a part of the base material 111. The insulating material 143 is coated on the base material 111 by vapor deposition, spraying or the like. A resin film such as polyimide, for example, may be used as the insulating material 143. The insulating material 143 preferably has elasticity.

The structure of the type-II sheet battery 210 is described next. The sheet battery 210 has a planar shape that is symmetrical to the sheet battery 110. To be specific, the sheet battery 210 and the sheet battery 110 are symmetric with respect to a line parallel to the Y direction.

The sheet battery 210 has a rectangular part 231 and a tab part 232. The rectangular part 231 may be oblong or square on the X-Y plane. In this example, the rectangular part 231 has an oblong shape having sides parallel to the X direction and the Y direction, with their longer sides along the X direction. The tab part 232 juts out in the +Y direction from the rectangular part 231. Specifically, the tab part 232 projects outward from one side along the X direction of the rectangular part 231. In this example, the sheet battery 210 is inverted L-shaped on the X-Y plane. The tab part 232 is formed at the -X and +Y side edge of the rectangular part 231.

A base material 211 in Fig. 2 corresponds to the base material 11 in Fig. 1. Likewise, a laminate 220 in Fig. 2 corresponds to the laminate 20 in Fig. 1. Thus, the laminate 220 includes the n-type oxide semiconductor layer 13, the charging layer 14, the p-type oxide semiconductor layer 16 and the second electrode 17 as shown in Fig. 1. The laminated construction of the laminate 220 is the same as that of the laminate 120.

A major part of the laminate 220 is formed in the rectangular part 231 and the tab part 232. The uppermost surface is the second electrode 17 in the most part of the rectangular part 231 and the tab part 232. In the area where the laminate 220 is not placed, the base material 211 is exposed to the outside. Therefore, the uppermost surface is the base material 211 in the peripheral part of the sheet battery 210.

Further, an insulating material 243 is formed on the sheet battery 210. As shown in Fig. 2, the insulating material 243 is formed as a part of the rectangular part 231. To be specific, the tab part 232 is formed at the -X and +Y side edge of the rectangular part 231, and the insulating material 243 is formed at the +X and +Y side edge of the rectangular part 131. The insulating material 243 is placed along the X direction.

The insulating material 243 is placed on the outside of the laminate 220. Specifically, the insulating material 243 is formed in the area where the uppermost surface is the base material 211. The insulating material 243 is formed directly on the base material 211 so as to be in contact with the base material 211. The insulating material 243 is formed to cover a part of the base material 211. The insulating material 243 is coated on the base material 211 by vapor deposition, spraying or the like. A resin film such as polyimide, for example, may be used as the insulating material 243. The insulating material 243 preferably has elasticity.

The insulating material 143 is placed to prevent the base material 111 from being short-circuited with the second electrode 17 of the other sheet battery 110 when the sheet batteries 110, 210 are laminated together. Likewise, the insulating material 243 is placed to prevent the base material 211 from being short-circuited with the second electrode 17 of the other sheet battery 210 when the sheet batteries 210 are laminated together.

Note that the type-I sheet battery 110 and the type-II sheet battery 210 are different only in the positions of the tab parts 132 and 232 and the insulating materials 143 and 243 in the X direction. For example, the rectangular part 231 has the same size as the rectangular part 131. Further, the tab part 232 has the same size as the tab part 132.

### (Battery Structure with Lamination of Two Sheets)

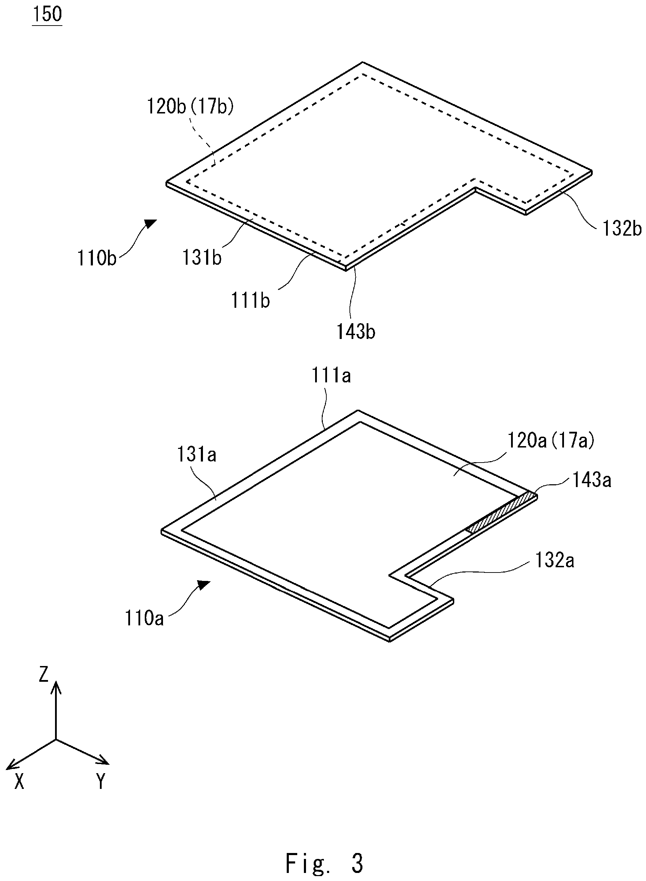

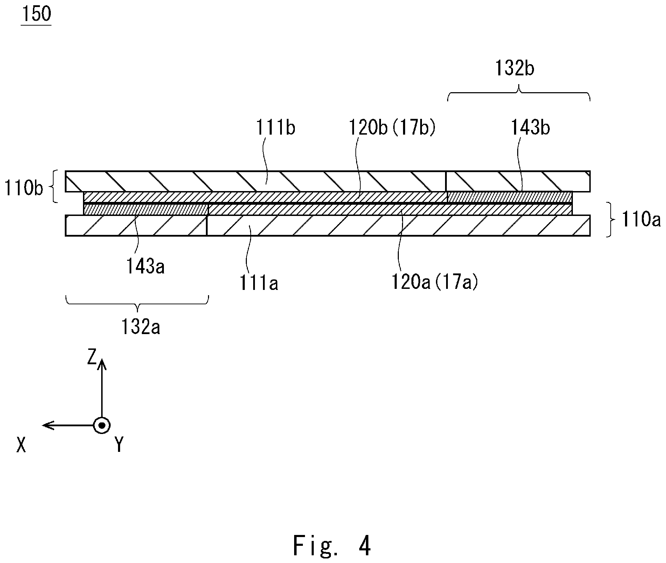

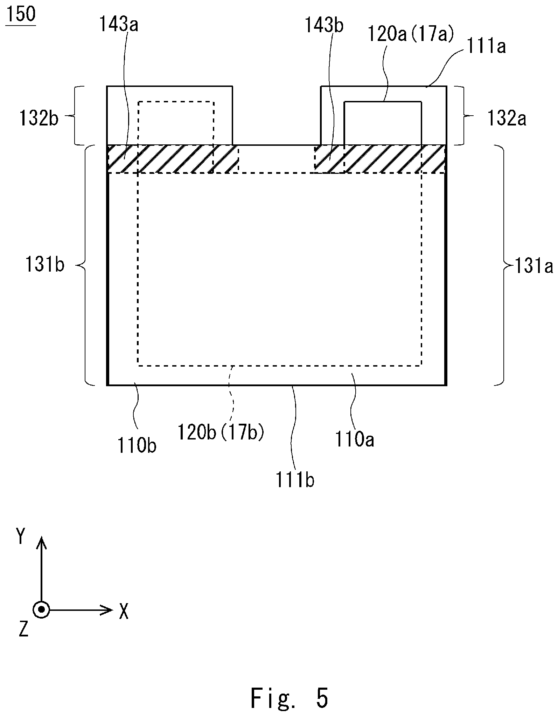

A battery structure where two sheet batteries 110 are laminated together is described hereinafter with reference to Figs. 3 to 5. Hereinafter, the battery structure where two sheet batteries 110 are laminated together is described as a sheet pair 150. Fig. 3 is an exploded perspective view of the sheet pair 150. Fig. 4 is an X-Z plane view showing the side structure of the sheet pair 150. Fig. 5 is an X-Y plane view showing the planar shape of the sheet pair 150.

The sheet pair 150 has a pair of two sheet batteries 110a and 110b. In the sheet pair 150, the two sheet batteries 110a and 110b are connected. Note that, in the figures described hereinbelow, a plane on which the sheet batteries 110a and 110b are placed is an X-Y plane, just like in Fig. 2. Further, a direction orthogonal to the X-Y plane is the Z direction. An XYZ orthogonal coordinate system where the in-plane directions of the sheet batteries 110a and 110b are the X direction and the Y direction and the thickness direction of the sheet pair 150 is the Z direction is used in the following description.

Further, for the sake of description, +Z side is the upper side, and the -Z side is the lower side. The sheet battery 110b is placed on the upper side of the sheet battery 110a.

To distinguish between the elements of the two sheet batteries 110a and 110b, the alphabet "a" or "b" is added after the reference numeral. For example, the insulating material 143, the rectangular part 131, the tab part 132, the second electrode 17 and the laminate 120 included in the sheet battery 110a are the insulating material 143a, the rectangular part 131a, the tab part 132a, the second electrode 17a and the laminate 120a, respectively. Likewise, the insulating material 143, the rectangular part 131, the tab part 132, the second electrode 17 and the laminate 120 included in the sheet battery 110b are the insulating material 143b, the rectangular part 131b, the tab part 132b, the second electrode 17b and the laminate 120b, respectively. Note that, to clarify the description, the reference symbols of the laminate 120a, 120b and the second electrode 17a, 17b are shown side by side in the figures as appropriate. Further, when there is no need to distinguish between the two sheet batteries 110a and 110b, the alphabet "a" or "b" after the reference numeral is omitted as appropriate.

The sheet pair 150 includes the sheet battery 110a, which is a first sheet battery, and the sheet battery 110b, which is a second sheet battery. The tab part 132a of the sheet battery 110a is a first tab part, and the tab part 132b of the sheet battery 110b is a second tab part. Likewise, the insulating material 143a placed in the sheet battery 110a is a first insulating material, and the insulating material 143b placed in the sheet battery 110b is a second insulating material.

The sheet battery 110a and the sheet battery 110b are placed with the second electrodes 17a and 17b facing each other. Thus, the sheet battery 110b is inverted relative to the sheet battery 110a so that the second electrode 17b faces in the -Z direction. To be specific, rotating the sheet battery 110 in Fig. 2 by 180° about the Y axis being the axis of rotation gives the orientation of the sheet battery 110b. The orientation of the sheet battery 110a is the same as that of the sheet battery 110 in Fig. 2.

The second electrode 17a of the sheet battery 110a is placed facing upward, and the second electrode 17b of the sheet battery 110b is placed facing downward. Thus, as shown in Fig. 4, the laminate 120a is placed on the upper side of the base material 111a in the sheet battery 110a, and the laminate 120b is placed on the lower side of the base material 111b in the sheet battery 110b. The sheet battery 110a and the sheet battery 110b are laminated together in such a way that the rectangular part 131a and the rectangular part 131b overlap each other when the XY plane is viewed from above.

In the sheet pair 150, the second electrode 17a of the sheet battery 110a and the second electrode 17b of the sheet battery 110b are placed face-to-face with each other and connected. The second electrode 17a is exposed on the upper surface of the sheet battery 110a, and the second electrode 17b is exposed on the lower surface of the sheet battery 110b. Accordingly, by placing the second electrode 17a of the sheet battery 110a and the second electrode 17b of the sheet battery 110b facing each other, the second electrode 17a and the second electrode 17b come into contact with each other. The second electrode 17a of the sheet battery 110a and the second electrode 17b of the sheet battery 110b thereby become electrically continuous.

Because the sheet battery 110b is inverted relative to the sheet battery 110a, the tab part 132a and the tab part 132b are arranged in a staggered fashion on the X-Y plane. Specifically, the tab part 132a is placed at the +X side edge of the sheet battery 110a, and the tab part 132b is placed at the -X side edge of the sheet battery 110b. In this manner, the position of the tab part 132a and the position of the tab part 132b in the X direction are different. The tab part 132a and the tab part 132b are staggered on the X-Y plane. In other words, the tab part 132a of the sheet battery 110a projects to the outer side of the sheet battery 110b on the X-Y plane. Likewise, the tab part 132b of the sheet battery 110b projects to the outer side of the sheet battery 110a on the X-Y plane.

Further, the insulating material 143b is formed on the lower surface of the sheet battery 110b. The insulating material 143b is placed in close proximity to the tab part 132a. The insulating material 143b is placed at the edge of the sheet battery 110b. A "close" position is a position where the laminate 120b of the sheet battery 110b is not placed and which corresponds to the tab part 132a, for example. The insulating material 143b is placed between the sheet battery 110a and the sheet battery 110b in the position extending to the tab part 132a of the sheet battery 110a. In other words, the insulating material 143b is placed in the area of the rectangular part 131a at the boundary between the tab part 132a and the rectangular part 131a of the sheet battery 110a on the X-Y plane. The insulating material 143b is thereby interposed between the second electrode 17a on the uppermost surface of the laminate 120a in close proximity to the tab part 132a and the base material 111b of the sheet battery 110b. It is thus possible to prevent short-circuit between the second electrode 17a of the sheet battery 110a and the base material 111b of the sheet battery 110b.

Further, the insulating material 143a is formed on the upper surface of the sheet battery 110a. The insulating material 143a is placed in close proximity to the tab part 132a. The insulating material 143a is placed at the edge of the sheet battery 110a. The insulating material 143a is placed between the base material 111a of the sheet battery 110a and the laminate 120b of the sheet battery 110b.

To be specific, the insulating material 143a is formed in a position where the laminate 120a of the sheet battery 110a is not placed and which corresponds to the tab part 132b. The insulating material 143a is placed between the sheet battery 110a and the sheet battery 110b in the position extending to the tab part 132b of the sheet battery 110b. In other words, the insulating material 143a is placed in the area of the rectangular part 131b at the boundary between the tab part 132b and the rectangular part 131b of the sheet battery 110b on the X-Y plane.

The insulating material 143a is thereby interposed between the second electrode 17b on the uppermost surface of the laminate 120b in close proximity to the tab part 132b and the base material 111a of the sheet battery 110a. It is thus possible to prevent short-circuit between the second electrode 17a of the sheet battery 110a and the base material 111b of the sheet battery 110b.

As described above, the tab part 132a and the tab part 132b are staggered in position in the X direction. Therefore, in this embodiment, there is an area where the second electrode 17 of one sheet battery 110 and the base material 111 of the other sheet battery 110 face each other at the boundary between the tab part 132 and the rectangular part 131. In this embodiment, the insulating material 143 is placed in this area. In other words, the insulating material 143 is placed between the sheet battery 110a and the sheet battery 110b in the area where the base material 111 is exposed. By placing the insulating material 143 in this exposure position, it is possible to prevent the second electrode 17 from being short-circuited with the first electrode of the other sheet battery 110.

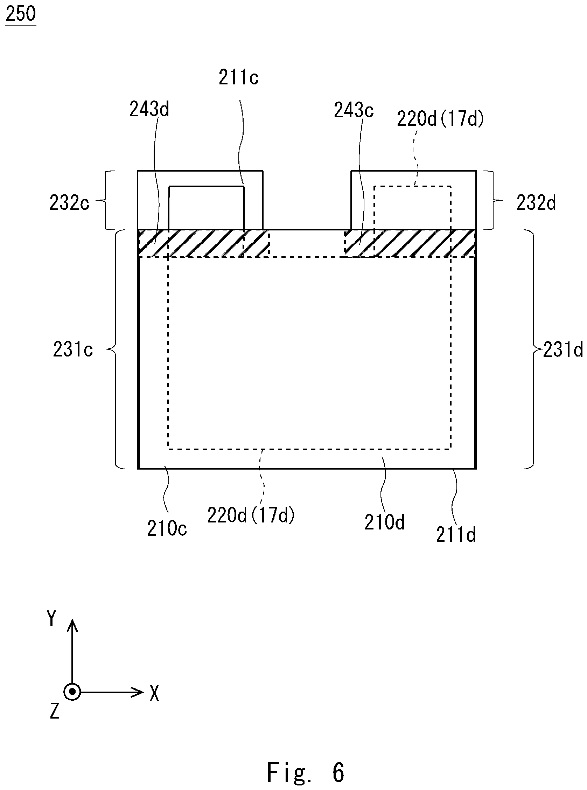

Note that the sheet batteries 210 are also laminated in the same manner to form a sheet pair. The two sheet batteries 210 are placed with their second electrodes facing each other and being connected. Fig. 6 shows the X-Y plane shape of a sheet pair 250 that includes sheet batteries 210c and 210d. Note that the laminated construction of the sheet pair 250 is the same as that of the sheet pair 150 and therefore the description thereof is omitted.

In the sheet pair 250, the type-II sheet batteries 210c and 210d shown in Fig. 2 are laminated together with the laminate 220c and the laminate 220d facing each other. To be specific, the laminate 220c of the sheet battery 210c faces upward, and the laminate 220d of the sheet battery 210d faces downward. Specifically, rotating the sheet battery 210 in Fig. 2 by 180° about the Y axis being the axis of rotation gives the orientation of the sheet battery 210d. The sheet battery 210c and the sheet battery 210d are placed in such a way that their second electrodes 17 face each other and are connected.

In the sheet pair 250, the positions of the tab parts 232c and 232d along the X direction are different. The tab part 232c is placed at the -X side edge, and the tab part 232d is placed at the +X side edge. The tab part 232c of the sheet battery 210c projects to the outer side of the sheet battery 210d on the X-Y plane. Likewise, the tab part 132d of the sheet battery 210d projects to the outer side of the sheet battery 210c on the X-Y plane.

As described above, two kinds of sheet pairs 150 and 250 are used in this embodiment. Note that, in a sheet pair composed of two sheet batteries of the same type, the positions of the tab parts are different on the X-Y plane where the sheet batteries are laminated. Specifically, in the sheet pair, the tab part of one sheet battery protrudes to the outside of the other sheet battery. The sheet pair 150 is referred to as a first sheet pair 150, and the sheet pair 250 is referred to as a second sheet pair 250.

When laminating the sheet pairs 150 and 250 together, the sheet batteries 110 and 210 are laminated in such a way that the rectangular parts 131 and 231 overlap each other. Thus, on the X-Y plane, the tab part 232c of the sheet pair 250 overlaps the tab part 132a of the sheet pair 150, and the tab part 232d of the sheet pair 250 overlaps the tab part 132b of the sheet pair 150. Note that the tab part 132a and the tab part 232c are placed with the laminates 120a and 220c facing the +Z side, and the tab part 132b and the tab part 232d are placed with the laminates 120b and 220d facing the -Z side.

### (Laminated Battery)

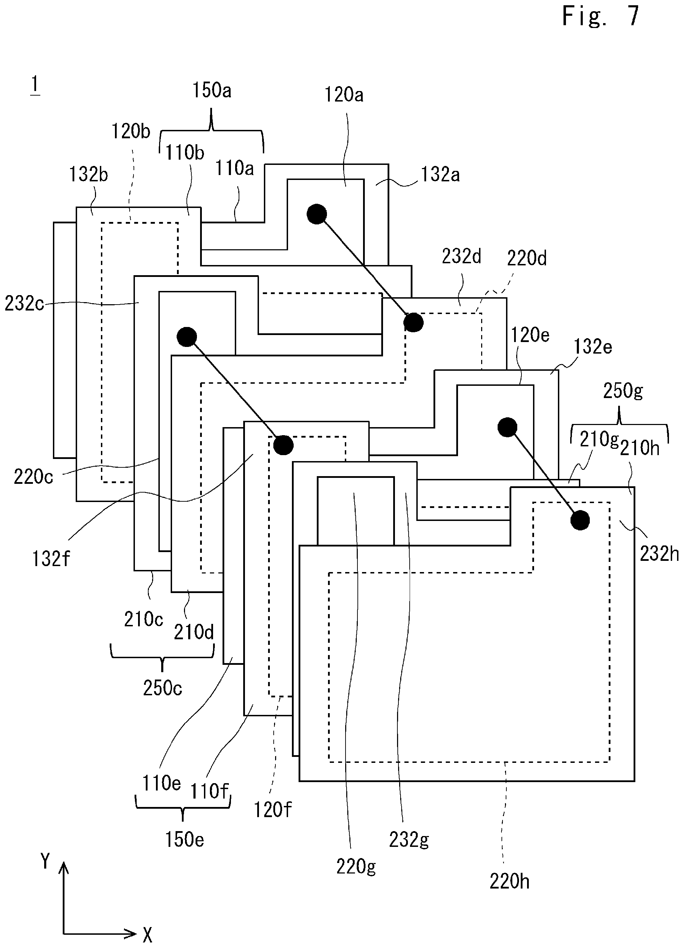

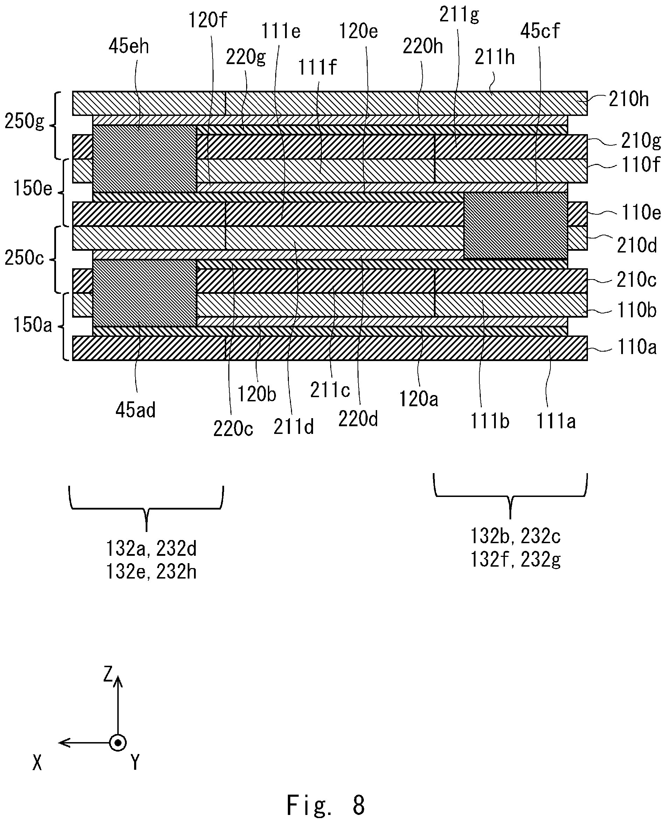

The structure of a laminated battery having a plurality of sheet pairs is described hereinafter with reference to Figs. 7 and 8. Fig. 7 is a schematic view showing the structure of a laminated battery 1. Fig. 8 is an X-Z plane view showing the side structure of the laminated battery 1. Note that, in the laminated battery 1, the sheet batteries 110 and 210 are laminated with their substantially whole areas overlapping each other. In Fig. 8, the sheet batteries 110 and 210 are partly displaced to clarify the description.

Figs. 7 and 8 show the laminated battery 1 that includes 8 sheet batteries 110a, 110b, 210c, 210d, 110e, 110f, 210g, and 210h. The sheet batteries 110a, 110b, 110e and 110f are the type-I sheet batteries 110 shown in Fig. 2. The sheet batteries 210c, 210d, 210g and 210h are the type-II sheet batteries 210 show in Fig. 2.

In Figs. 7 and 8, tab parts placed in the sheet batteries 110a, 110b, 110e and 110f are tab parts 132a, 132b, 132e and 132f, respectively. Laminates placed in the sheet batteries 110a, 110b, 110e and 110f are laminates 120a, 120b, 120e and 120f, respectively. Likewise, tab parts placed in the sheet batteries 210c, 210d, 210g and 210h are tab parts 232c, 232d, 232g and 232h, respectively. Laminates placed in the sheet batteries 210c, 210d, 210g and 210h are laminates 220c, 220d, 220g and 220h, respectively. Further, in Fig. 8, base materials placed in the sheet batteries 110a, 110b, 110e and 110f are base materials 111a, 111b, 111e and 111f, respectively, and base materials placed in the sheet batteries 210c, 210d, 210g and 210h are base materials 211c, 211d, 211g and 211h, respectively.

In the following description, when there is no particular need to distinguish among the sheet batteries 110a, 110b, 210c, 210d, 110e, 110f, 210g, and 210h, the alphabet "a" to "h" are omitted and they are simply referred to as the sheet batteries 110 and 210, which is the same for the other elements.

As shown in Fig. 8, the sheet batteries 110a, 110b, 210c, 210d, 110e, 110f, 210g, and 210h are laminated in this order. In Fig. 8, the sheet battery 110a is placed on the lowermost side, and the sheet battery 210h is placed on the uppermost side. Note that the sheet batteries 110a, 110b, 210c, 210d, 110e, 110f, 210g, and 210h are sequentially referred to as a first sheet battery 110a to an eighth sheet battery 210h, which is the same for the other elements.

In Figs. 7 and 8, sheet pairs composed of the type-I sheet batteries 110 are sheet pairs 150a and 150e. The first sheet pair 150a has two sheet batteries 110a and 110b. The sheet pair 150e has two sheet batteries 110e and 110f. Likewise, sheet pairs composed of the type-II sheet batteries 210 are sheet pairs 250c and 250g. The second sheet pair 250c has two sheet batteries 210c and 210d. The sheet pair 250g has two sheet batteries 210g and 210h.

In the sheet pair 150a, the laminate 120a and the laminate 120b are placed facing each other, and therefore the second electrodes 17 (not shown in Figs. 7 and 8) are connected to each other as shown in Fig. 4. Likewise, in the sheet pair 150e, the laminate 120e and the laminate 120f are placed facing each other, and therefore the second electrodes 17 (not shown in Figs. 7 and 8) are connected to each other. In the sheet pair 250c, the laminate 220c and the laminate 220d are placed facing each other, and therefore the second electrodes 17 (not shown in Figs. 7 and 8) are connected to each other. Likewise, in the sheet pair 250g, the laminate 220g and the laminate 220h are placed facing each other, and therefore the second electrodes 17 (not shown in Figs. 7 and 8) are connected to each other. In this manner, the positive electrodes are connected to each other in each of the sheet pairs 150a, 150e, 250c and 250g.

As shown in Fig. 8, the sheet batteries 110b, 210d, 110f and 210h are placed in such a way that the laminates 120b, 220d, 120f and 220h face downward. For example, in the second sheet battery 110b, the base material 111b is placed on the upper side of the laminate 120b. In the fourth sheet battery 210d also, the base material 211d is placed on the upper side of the laminate 220d. In the sixth sheet battery 110f also, the base material 111f is placed on the upper side of the laminate 120f. In the eighth sheet battery 210h also, the base material 211h is placed on the upper side of the laminate 220h.

On the other hand, as shown in Fig. 8, the sheet batteries 110a, 210c, 110e and 210g are placed in such a way that the laminates 120a, 220c, 120e and 220g face upward. In the first sheet battery 110a, the base material 111a is placed on the lower side of the laminate 120a. In the third sheet battery 210c also, the base material 211c is placed on the lower side of the laminate 220c. In the fifth sheet battery 110e also, the base material 111e is placed on the lower side of the laminate 120e. In the seventh sheet battery 210g also, the base material 211g is placed on the lower side of the laminate 220g.

As shown in Fig. 8, the orientations of the base material and the laminate are vertically inverted between the odd-numbered sheet batteries 110a, 210c, 110e and 210g and the even-numbered sheet batteries 110b, 210d, 110f and 210h in their laminated structures.

Therefore, the base material 111b of the second sheet battery 110b and the base material 211c of the third sheet battery 210c are placed face-to-face with each other and connected. Likewise, the base material 211d of the fourth sheet battery 210d and the base material 111e of the fifth sheet battery 110e are placed face-to-face with each other and connected. The base material 111f of the sixth sheet battery 110f and the base material 211g of the seventh sheet battery 210g are placed face-to-face with each other and connected.

The sheet batteries 110a, 110b, 110e and 110f are the type-I sheet batteries 110 shown in Fig. 2, and the sheet batteries 210c, 210d, 210g and 210h are the type-II sheet batteries 210 show in Fig. 2. The orientation of the laminate is different between the even-numbered sheet batteries and the odd-numbered sheet batteries.

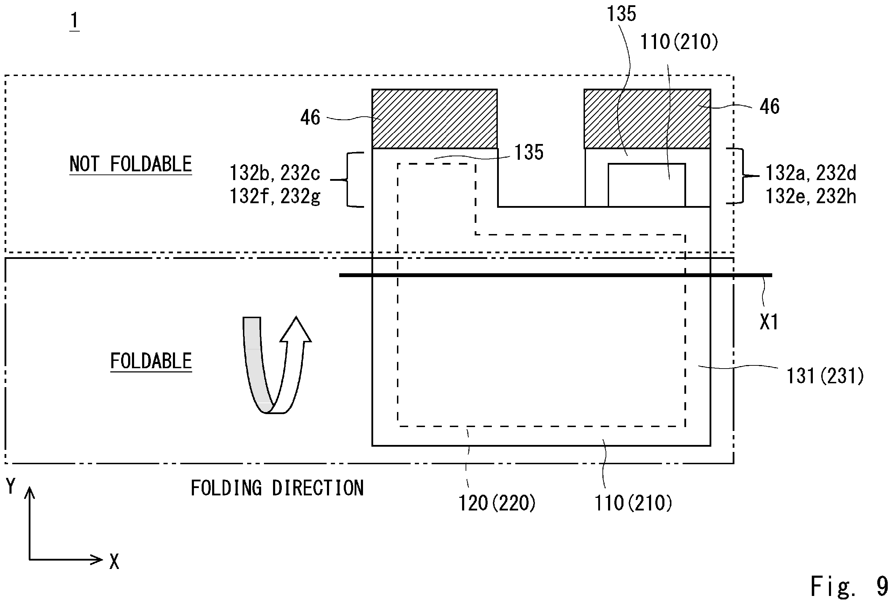

Thus, the tab parts 132a, 232d, 132e and 232h of the first sheet battery 110a, the fourth sheet battery 210d, the fifth sheet battery 110e and the eighth sheet battery 210h are placed at the +X side edge. The tab parts 132a, 232d, 132e and 232h thereby overlap each other on the X-Y plane (refer also to Fig. 9).

The tab parts 132b, 232c, 132f and 232g of the second sheet battery 110b, the third sheet battery 210c, the sixth sheet battery 110f and the seventh sheet battery 210g are placed at the -X side edge. The tab parts 132b, 232c, 132f and 232g thereby overlap each other on the X-Y plane (refer also to Fig. 9). Further, the tab parts 132b, 232c, 132f and 232g and the tab parts 132a, 232d, 132e and 232h are arranged in a staggered fashion on the X-Y plane.

Because the first tab part 132a overlaps the fourth tab part 232d, the second electrode 17 of the first tab part 132a and the second electrode 17 of the fourth tab part 232d are placed face-to-face with each other. The second electrode 17 of the first tab part 132a and the second electrode 17 of the fourth tab part 232d can be thereby easily connected.

To be specific, the laminated battery 1 has a conductive bonding agent 45ad so as to connect the second electrode 17 of the first tab part 132a and the second electrode 17 of the fourth tab part 232d. Specifically, the first tab part 132a and the fourth tab part 232d are bonded together, and the second electrode 17 of the first sheet battery 110a and the second electrode 17 of the fourth sheet battery 210d are connected through the conductive bonding agent 45ad. The second electrodes 17 of the two adjacent sheet pairs 150a and 250c are thereby connected. Because the two sheet batteries 110b and 210c are placed between the first sheet battery 110a and the fourth sheet battery 210d, the conductive bonding agent 45ad corresponds to the thickness of the two sheet batteries.

Likewise, because the third tab part 232c overlaps the sixth tab part 132f, the second electrode 17 of the third tab part 232c and the second electrode 17 of the sixth tab part 132f are placed face-to-face with each other. The second electrode 17 of the third tab part 232c and the second electrode 17 of the sixth tab part 132f can be thereby easily connected.

To be specific, the laminated battery 1 has a conductive bonding agent 45cf so as to connect the second electrode 17 of the third tab part 232c and the second electrode 17 of the sixth tab part 132f. Specifically, the third tab part 232c and the sixth tab part 132f are bonded together, and the second electrode 17 of the third sheet battery 210c and the second electrode 17 of the sixth sheet battery 110f are connected through the conductive bonding agent 45cf. The second electrodes 17 of the two adjacent sheet pairs 150e and 250c are thereby connected. Because the two sheet batteries 210d and 110e are placed between the third sheet battery 210c and the sixth sheet battery 110f, the conductive bonding agent 45cf corresponds to the thickness of the two sheet batteries.

Further, because the fifth tab part 132e overlaps the eighth tab part 232h, the second electrode 17 of the fifth tab part 132e and the second electrode 17 of the eighth tab part 232h are placed face-to-face with each other. The second electrode 17 of the fifth tab part 132e and the second electrode 17 of the eighth tab part 232h can be thereby easily connected.

To be specific, the laminated battery 1 has a conductive bonding agent 45eh so as to connect the second electrode 17 of the fifth tab part 132e and the second electrode 17 of the eighth tab part 232h. Specifically, the fifth tab part 132e and the eighth tab part 232h are bonded together, and the second electrode 17 of the fifth sheet battery 110e and the second electrode 17 of the eighth sheet battery 210h are connected through the conductive bonding agent 45eh. The second electrodes 17 of the two adjacent sheet pairs 150e and 250g are thereby connected. Because the two sheet batteries 110f and 210g are placed between the fifth sheet battery 110e and the eighth sheet battery 210h, the conductive bonding agent 45eh corresponds to the thickness of the two sheet batteries.

As described above, use of the conductive bonding agents 45ad, 45cf and 45eh allows all the second electrodes 17 of the eight sheet batteries 110 and 210 to be connected in parallel. This eliminates the need for tab leads and comb-like electrodes for connecting the second electrodes 17. It is thereby possible to reduce the number of parts and simplify the structure and the fabrication process. The productivity of the laminated battery is thereby improved. Each of the conductive bonding agents 45ad, 45cf and 45eh has a thickness corresponding to two sheets batteries, which reduces the thickness of the laminated battery. It is thereby possible to save the space.

The thickness of the bonding agent 45 is substantially equal to the total thickness of two sheets batteries. It is thereby possible to reduce a difference in thickness even when the number of laminated sheet batteries 110 and 210 is large. Easier lamination is achieved by making the thickness of a sheet pair equal to the thickness of a conductive bonding agent.

Further, because a lamination method is simple, it is possible to reduce manufacturing costs without adding an extra step. It is thereby possible to achieve a thinner laminated battery easily. Furthermore, because a plurality of sheet batteries 110 are connected in parallel, it is possible to achieve high-capacity

Note that, although the laminated battery 1 that includes four sheet batteries 110 and four sheet batteries 210 is described in this embodiment, the total number of sheet batteries 110 and 210 included in the laminated battery 1 is not limited to 8. The laminated battery 1 includes at least one sheet pair 150 and one sheet pair 250. In other words, the laminated battery 1 includes four or more sheet batteries 110 and 210.

Further, the laminated battery 1 preferably includes a plurality of sets of the sheet pair 150 and the sheet pair 250, i.e., four sheet batteries 110 and 210. For example, the total number of sheet batteries 110 and 210 included in the laminated battery 1 may be 12 or 16. In this case, the sheet batteries 110 and 210 are laminated in such a way that the sheet pair 150 and the sheet pair 250 are arranged alternately.

Further, the laminated battery 1 may be folded. A structure of folding the laminated battery 1 is described hereinafter with reference to Fig. 9. Fig. 9 is a plan view illustrating, in a simple way, the structure of the laminated battery 1 where a plurality of sheet batteries 110 and 210 are laminated.

As shown in Fig. 9, the laminated battery 1 can be folded along a fold line X1 in parallel with the X direction. Folding the laminated battery 1 allows the area on the X-Y plane to be reduced half, thereby easily reducing the size of the laminated battery 1. The fold line X1 does not lie across the tab parts 132 and 232. Only the rectangular parts 131 and 231 are thereby folded. Thus, the laminated battery 1 is folded without folding the tab parts 132 and 232.

Further, areas of the tab parts 132 and 232 which are on the +Y side of the laminate 120 are joint regions 135 and 235. The joint regions 135 and 235 are peripheral areas of the base materials 111 band 211, respectively. In the peripheral areas of the base materials 111 band 211, the laminate 120 is not placed, and the base materials 111 band 211 are exposed. Specifically, in the joint regions 135 and 235, the base materials 111 band 211 are exposed on the surfaces of the both sheet batteries 110 and 210. A joint part 46 joins the joint regions 135 and 235 together. In this manner, in the joint part 46, the peripheral areas of the base materials 111 and 211 of the sheet battery 110 and the sheet battery 210 are joined together.

The joint part 46 is formed by welding such as resistance welding or ultrasonic welding, for example. The first electrodes of all the sheet batteries 110 and 210 are thereby connected. The plurality of sheet batteries 110 and 210 can be thereby connected in parallel. Further, all the sheet batteries 110 and 210 are bonded together in the joint part 46. Thus easily reduces the size of the laminated battery 1.

### Second Embodiment

### (Planar Shape of Sheet Battery)

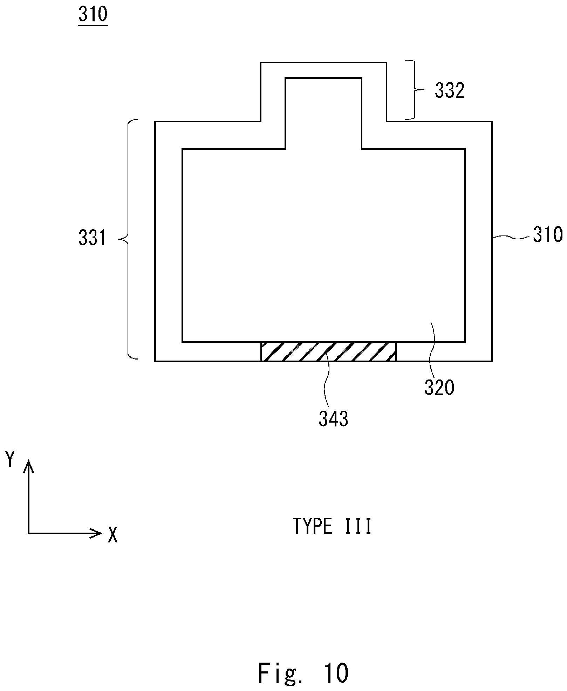

This embodiment is the same as the first embodiment in that sheet batteries are laminated, and is different from the first embodiment in the planar shape of sheet batteries. The planar shape of a sheet battery 310 according to this embodiment is described hereinafter with reference to Fig. 10. Note that, in this embodiment, all of sheet batteries 310 have the same planar shape. Specifically, all of sheet batteries are the type III. Note that the description common to the first embodiment is omitted as appropriate below.

The type-III sheet battery 310 is different from the type-I sheet battery 110 and the type-II sheet battery 210 in the positions of a tab part 332 and an insulating material 343. Note that the type-III sheet battery 310 is the same as the sheet batteries 110 and 210 of the first embodiment except for the position of the tab part 332, and the description thereof is omitted. For example, a base material 311 and a laminate 320 are the same as the base material 111 and the laminate 120, respectively, and the description thereof is omitted.

A rectangular part 331 is oblong or square on the X-Y plane. The tab part 332 projects in the +Y direction from the rectangular part 331. The tab part 332 is placed in the middle of the rectangular part 331 in the X direction.

The insulating material 343 is placed at the -Y side edge of the rectangular part 331. The insulating material 343 is placed in the middle of the rectangular part 331 in the X direction. Thus, the positions of the tab part 332 and the insulating material 343 in the X direction coincide with each other.

### (Battery Structure with Lamination of Two Sheets)

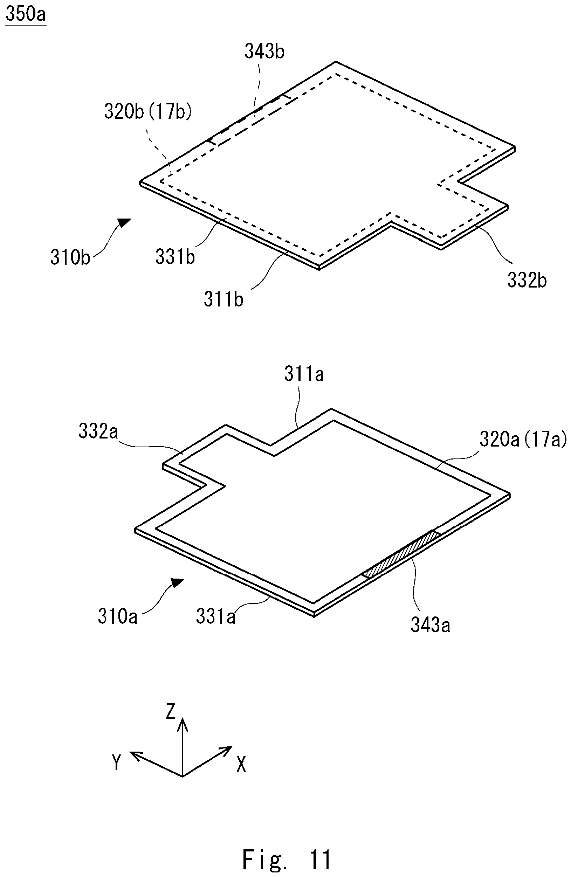

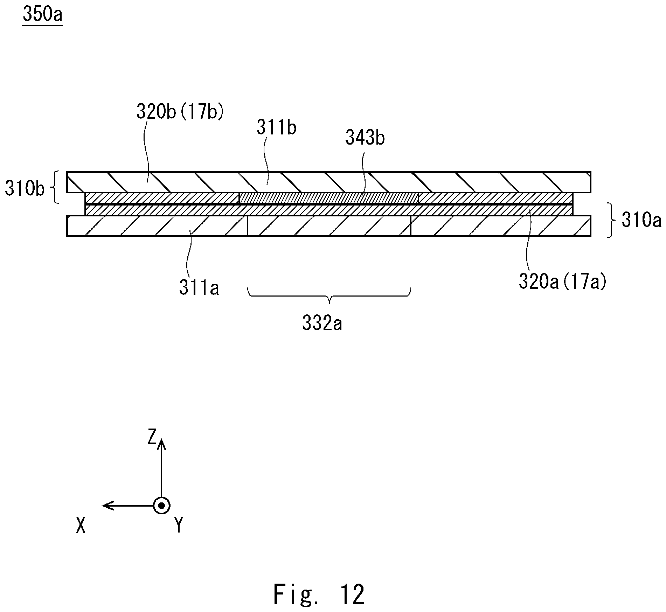

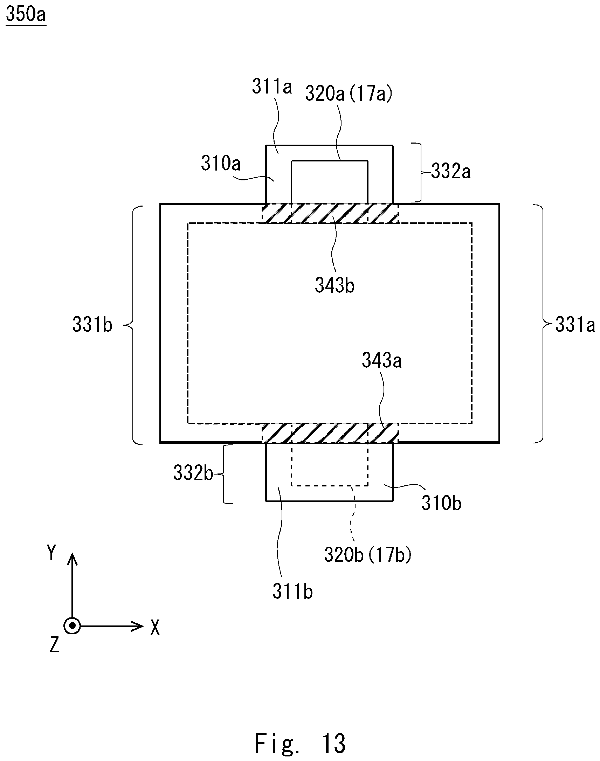

A battery structure where two sheet batteries 310 are laminated together is described hereinafter with reference to Figs. 11 to 13. Hereinafter, the battery structure where two sheet batteries 310a and 310b are laminated together is described as a sheet pair 350a. Fig. 11 is an exploded perspective view of the sheet pair 350a. Fig. 12 is an X-Z plane view showing the side structure of the sheet pair 350a. Fig. 13 is an X-Y plane view showing the planar structure of the sheet pair 350a.

The sheet battery 310a and the sheet battery 310b are placed with the second electrodes 17a and 17b facing each other. Thus, the sheet battery 310b has a structure that is the inverse of the sheet battery 310 in Fig. 10. To be specific, rotating the sheet battery 310 in Fig. 10 about the X axis being the axis of rotation gives the orientation of the sheet battery 310b. The sheet battery 310a is in the same orientation as the sheet battery 310 in Fig. 10.

The second electrode 17a of the sheet battery 310a is placed facing upward, and the second electrode 17b of the sheet battery 310b is placed facing downward. Thus, as shown in Fig. 12, the laminate 320a is placed on the upper side of the base material 311a in the sheet battery 310a, and the laminate 320b is placed on the lower side of the base material 311b in the sheet battery 310b. The sheet battery 310a and the sheet battery 310b are laminated together in such a way that the rectangular part 331a and the rectangular part 331b overlap each other when the XY plane is viewed from above.

In the sheet pair 350a, the second electrode 17a of the sheet battery 310a and the second electrode 17b of the sheet battery 310b are placed face-to-face with each other and connected. The second electrode 17a is exposed on the upper surface of the sheet battery 310a, and the second electrode 17b is exposed on the lower surface of the sheet battery 310b. The second electrode 17a of the sheet battery 310a and the second electrode 17b of the sheet battery 310b thereby become electrically continuous.

Further, a tab part 332a and a tab part 332b are placed in different positions on the X-Y plane. To be specific, the tab part 332a is placed at the +Y side edge, and the tab part 332b is placed at the -Y side edge. Therefore, just like in the first embodiment, the tab part 332a protrudes to the outside of the sheet battery 310b on the X-Y plane. The tab part 332b protrudes to the outside of the sheet battery 310a on the X-Y plane.

An insulating material 343b is placed in close proximity to the tab part 332a. Thus, the insulating material 343b is thereby interposed between the base material 311b and the second electrode 17a of the sheet battery 310a. This prevents short-circuit between the base material 311b and the second electrode 17a of the sheet battery 310a. Likewise, an insulating material 343a is interposed between the base material 311a and the second electrode 17b of the sheet battery 310b, which prevents short-circuit.

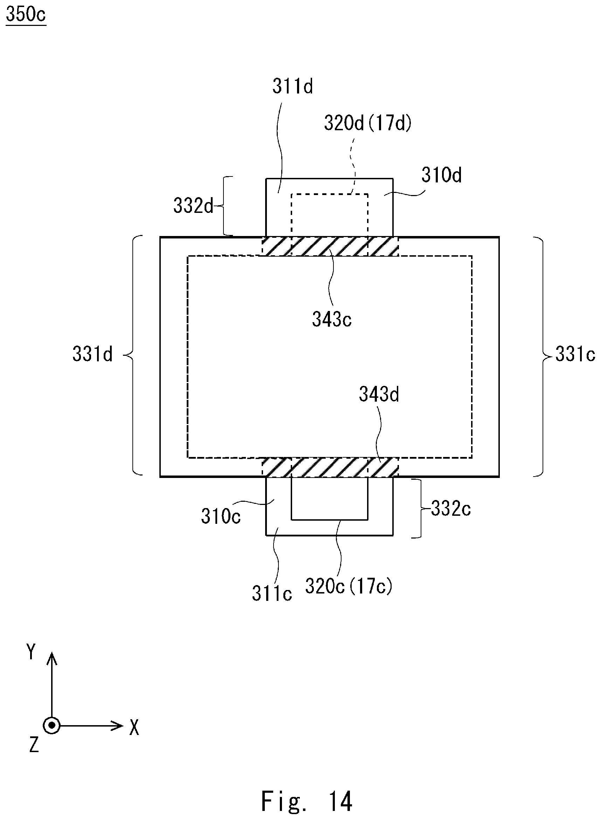

The structure of a sheet pair 350c having a different planar structure from the sheet pair 350a is described hereinafter with reference to Fig. 14. The sheet pair 350c includes a sheet battery 310c and a sheet battery 310d.

The sheet battery 310c and the sheet battery 310d are placed with second electrodes 17c and 17d facing each other. The second electrode 17c of the sheet battery 310c is placed facing upward, and the second electrode 17d of the sheet battery 310d is placed facing downward. Thus, rotating the planar shape of Fig. 13 by 180° about the Z axis being the axis of rotation gives the planar shape shown in Fig. 14. In this case, the sheet battery 310a corresponds to the sheet battery 310c, and the sheet battery 310b corresponds to the sheet battery 310d.

A tab part 332c and a tab part 332d are placed in different positions on the X-Y plane. To be specific, the tab part 332d is placed at the +Y side edge, and the tab part 332c is placed at the -Y side edge. Therefore, just like in the first embodiment, the tab part 332c protrudes to the outside of the sheet battery 310d on the X-Y plane, and the tab part 332d protrudes to the outside of the sheet battery 310c on the X-Y plane.

When laminating the sheet pair 350a and the sheet pair 350c together, they are laminated in such a way that the tab part 332a of the sheet battery 310a and the tab part 332d of the sheet battery 310d overlap each other on the X-Y plane. Likewise, the tab part 332b of the sheet battery 310b and the tab part 332c of the sheet battery 310c overlap each other on the X-Y plane. The tab part 332a and the tab part 332d are arranged in a staggered fashion on the X-Y plane.

### (Laminated Battery 3)

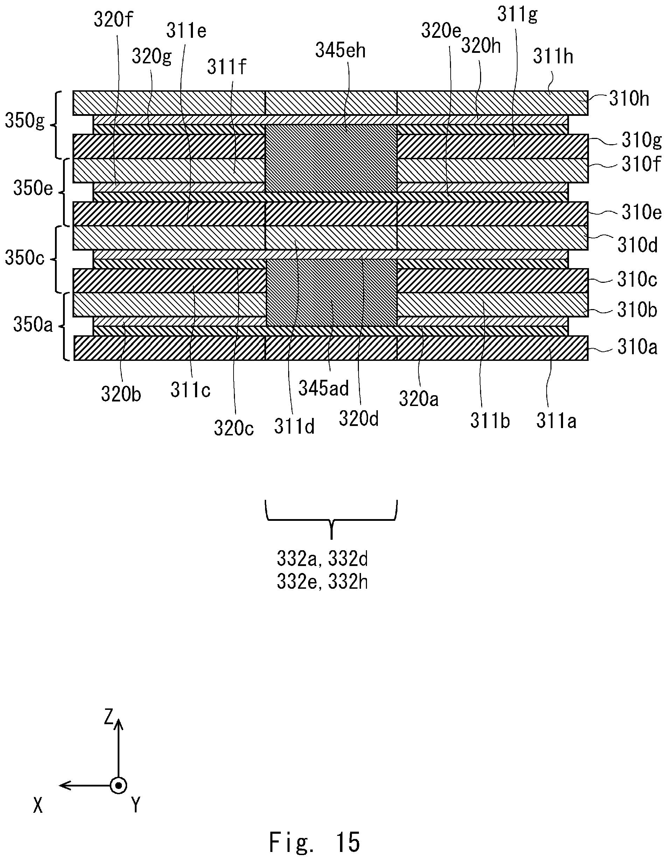

The structure of a laminated battery 3 where a plurality of sheet batteries 310 are laminated is described hereinafter with reference to Fig. 15. Fig. 15 is an X-Z plane view showing the laminated structure of the laminated battery 3.

The laminated battery 3 includes 8 sheet battery 310a to sheet battery 310h. As shown in Fig. 15, a sheet battery 310a, a sheet battery 310b, a sheet battery 310c, a sheet battery 310d, a sheet battery 310e, a sheet battery 310f, a sheet battery 310g, and a sheet battery 310h are laminated in this order from the bottom.

A sheet pair 350a includes the sheet battery 310a and the sheet battery 310b, having the planar shape shown in Fig. 13. A sheet pair 350c includes the sheet battery 310c and the sheet battery 310d, having the planar shape shown in Fig. 14.

A sheet pair 350e includes the sheet battery 310e and the sheet battery 310f, having the planar shape shown in Fig. 13. Thus, the sheet battery 310e has the same planar shape as the sheet battery 310a, and the sheet battery 310f has the same planar shape as the sheet battery 310d.

A sheet pair 350g includes the sheet battery 310g and the sheet battery 310h, having the planar shape shown in Fig. 14. Thus, the sheet battery 310g has the same planar shape as the sheet battery 310c, and the sheet battery 310h has the same planar shape as the sheet battery 310f.

Thus, the second electrodes are connected to each other in the tab parts, just like in the first embodiment. For example, in the tab parts 332a and 332d, the second electrode 17 (not shown in Fig. 15) of the sheet battery 310a and the second electrode 17 (not shown in Fig. 15) of the sheet battery 310d are connected through a conductive bonding agent 345ad. Further, in the tab parts 332e and 332h, the second electrode 17 (not shown in Fig. 15) of the sheet battery 310e and the second electrode 17 (not shown in Fig. 15) of the sheet battery 310h are connected through a conductive bonding agent 345eh. Note that, although not shown in Fig. 15, in the tab parts 332c and 332f, the second electrode 17 (not shown in Fig. 15) of the sheet battery 310c and the second electrode 17 (not shown in Fig. 15) of the sheet battery 310f are connected through a conductive bonding agent.

In this manner, the same effects as in the first embodiment are obtained. For example, because the need for tab leads and comb-like electrodes is eliminated, it is possible to reduce the number of parts and simplify the structure and the fabrication process. Further, it is possible to reduce the thickness of the laminated battery 3, just like in the first embodiment. Because one type of the sheet battery 310 is used in this embodiment, it is possible to further reduce the number of parts.

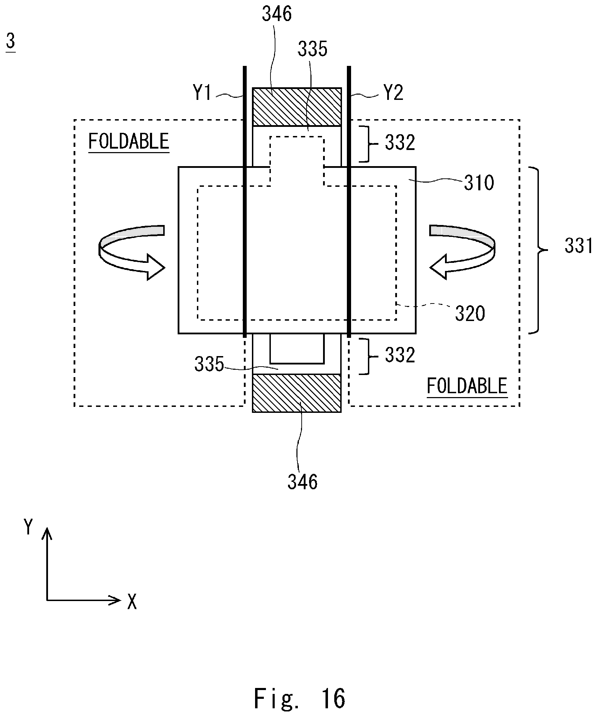

The laminated battery 3 having such a structure can be also folded like the laminated battery 1 of the first embodiment. For example, as shown in Fig. 16, the laminated battery 3 can be folded along fold lines Y1 and Y2 in parallel with the Y direction. The laminated battery 3 is thereby reduced in size. The fold lines Y1 and Y2 do not lie across the tab part 332. Thus, only the rectangular part 331 is folded.

As shown in Fig. 16, an area of the tab part 332 which is on the outer side of the laminate 320 is a joint region 335. In the joint region 335, the laminate 320 is not placed and therefore the base material 311 is exposed. Thus, in the joint region 335, the base material 311 is exposed on both surfaces of the sheet battery 310. A joint part 346 joins the joint region 335.

The joint part 346 is formed by welding such as resistance welding or ultrasonic welding, for example. The first electrodes of all the sheet batteries 310 are thereby connected. The plurality of sheet batteries 310 can be thereby connected in parallel. Further, all the sheet batteries 310 are bonded together in the joint part 346. Thus easily reduces the size of the laminated battery 3.

### Third Embodiment

### (Laminated Structure of Sheet Battery)

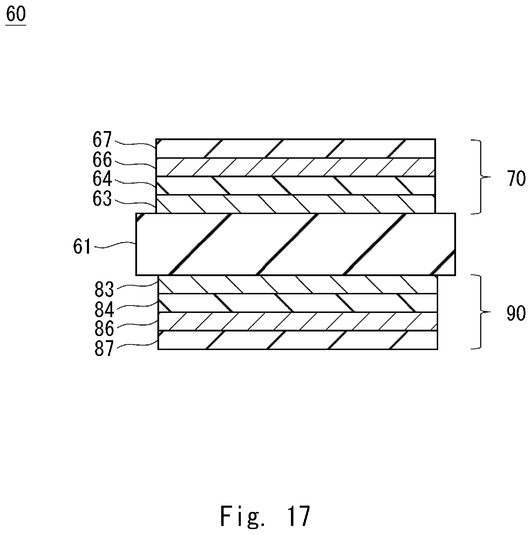

The cross-sectional structure of a sheet battery that is used in this embodiment is described hereinafter with reference to Fig. 17. Fig. 17 is a cross-sectional view showing the laminated structure of a sheet battery 60. A laminate 70 is placed on one surface of a base material 61, and a laminate 90 is placed on the other surface of the base material 61. Note that the description common to the first and second embodiments is omitted as appropriate below.

The laminated structure of the laminate 70 and the laminate 90 is the same as the laminate 20 described in the first embodiment. Specifically, the n-type oxide semiconductor layer 13, the charging layer 14, the p-type oxide semiconductor layer 16, and the second electrode 17 of the laminate 20 correspond to an n-type oxide semiconductor layer 63, a charging layer 64, a p-type oxide semiconductor layer 66, and a second electrode 67 of the laminate 70, respectively. Likewise, the n-type oxide semiconductor layer 13, the charging layer 14, the p-type oxide semiconductor layer 16, and the second electrode 17 of the laminate 20 correspond to an n-type oxide semiconductor layer 83, a charging layer 84, a p-type oxide semiconductor layer 86, and a second electrode 87 of the laminate 90, respectively.

Therefore, a second electrode 67 is placed on one surface of the base material 61, and a second electrode 87 is placed on the other surface of the base material 61.

In this embodiment, two types of sheet batteries are used. To be specific, the two types of sheet batteries are the sheet battery 60 where the laminate is placed on both surfaces of the base material 61 as shown in Fig. 17 and the sheet battery 10 where the laminate 20 is placed only on one surface of the base material 11 as shown in Fig. 1.

### (Planar Shape of Sheet Battery)

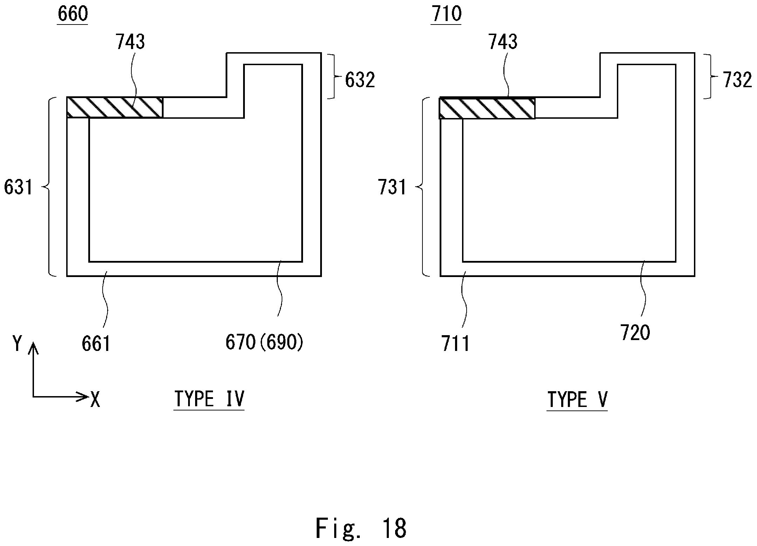

Fig. 18 shows the planar shapes of two types of sheet batteries. The sheet battery 60 where the laminate is placed on both surfaces is referred to as a type-IV sheet battery 660, and the sheet battery 10 where the laminate 20 is placed only on one surface is referred to as a type-V sheet battery 710. Note that the sheet battery 660 is also called a double-sided battery sheet, and the sheet battery 710 is also called a single-sided battery sheet.

In the sheet battery 660, a laminate 670 is formed on one surface of a base material 661. Note that the laminate formed on the other surface of the base material 661 is a laminate 690. The laminate 670 corresponds to the laminate 70 in Fig. 17. The laminate 690 corresponds to the laminate 90 in Fig. 17. The shape, size and position of the laminate 670 and the laminate 690 are the same on the X-Y plane.

In the sheet battery 710, a laminate 720 is formed on a base material 711. The size and shape of the laminate 720 are the same as those of the laminates 670 and 690.

The sheet battery 660 includes a rectangular part 631 and a tab part 632. The sheet battery 710 includes a rectangular part 731 and a tab part 732. The sheet battery 660 has an insulating material 643 for preventing short-circuit between the first electrode and the second electrode. The insulating material 643 may be placed on both surfaces or only on one surface of the base material 661. The sheet battery 710 has an insulating material 743 for preventing short-circuit between the first electrode and the second electrode. The shape, position and structure of the insulating materials 643 and 743 are the same as those of the insulating material 143 and therefore the description thereof is omitted.

The base material 661 of the sheet battery 660 and the base material 711 of the sheet battery 710 have the same shape as the base material 111 of the type-I sheet battery 110. The tab parts 632 and 732 are located in the same position as the tab part 132.

### (Battery Structure with Lamination of Two Sheets)

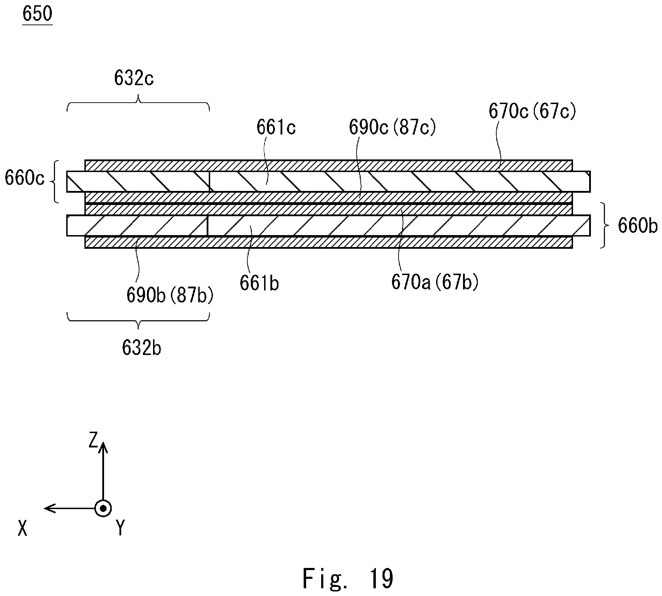

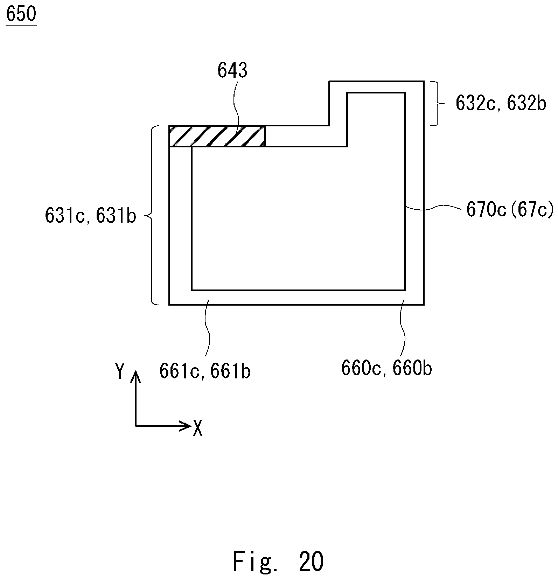

A battery structure where two sheet batteries 660 are laminated together is described hereinafter with reference to Figs. 19 and 20. Hereinafter, the battery structure where two sheet batteries 660 are laminated together is described as a sheet pair 650. Fig. 19 is an X-Z plane view showing the side structure of the sheet pair 650. Fig. 20 is an X-Y plane view showing the planar shape of the sheet pair 650.

The sheet pair 650 has a sheet battery 660b and a sheet battery 660c. The sheet battery 660c and the sheet battery 660b are type-IV sheet batteries 660 shown in Fig. 18. In the sheet pair 650, the two sheet battery 660c and sheet battery 660b overlap each other in the same orientation.

The sheet battery 660c and the sheet battery 660b are arranged completely overlapping each other. A tab part 632c of the sheet battery 660c and a tab part 632b of the sheet battery 660b are the same position in the X direction, which is different from the first and second embodiments. Thus, the tab part 632c of the sheet battery 660c and the tab part 632b of the sheet battery 660b overlap each other on the X-Y plane. A second electrode 67c of the sheet battery 660c and a second electrode 87b of the sheet battery 660b are connected face-to-face with each other.

### (Laminated Battery 6)

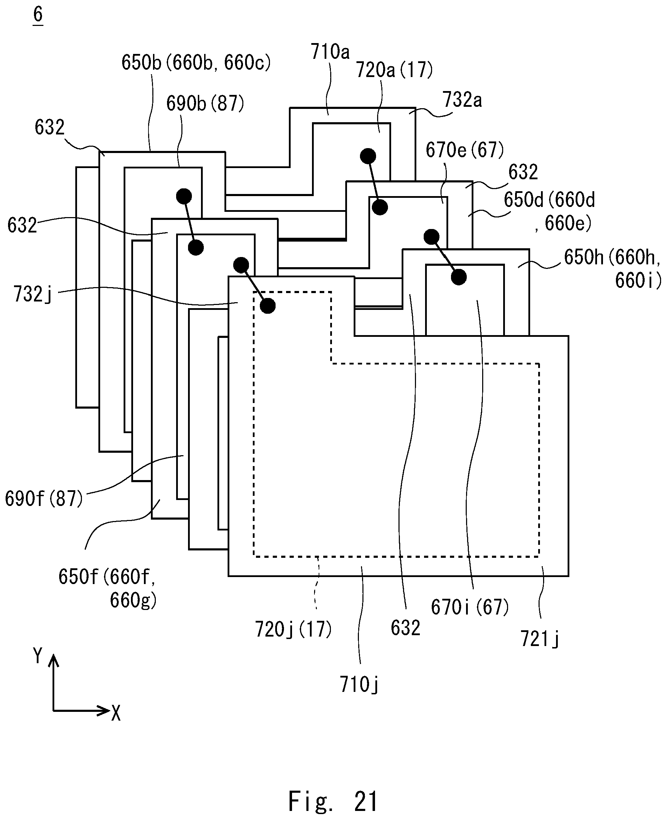

The structure of a laminated battery 6 where a plurality of sheet batteries 660 and 710 are laminated is described hereinafter with reference to Fig. 21. Fig. 21 is a view schematically showing the structure of the laminated battery 6.

The laminated battery 6 includes a sheet battery 710a, a sheet pair 650b, a sheet pair 650d, a sheet pair 650f, a sheet pair 650h, and a sheet battery 710j. The sheet battery 710a, the sheet pair 650b, the sheet pair 650d, the sheet pair 650f, the sheet pair 650h, and the sheet battery 710j are laminated in this order.

The sheet batteries 710a and 710j are the type-V sheet batteries 710 shown in Fig. 18. The sheet pairs 650b, 650d, 650f and 650h are the sheet pairs 650 shown in Figs. 19 and 20. The sheet pair 650 has two sheet batteries 660. Thus, the laminated battery 6 includes two sheet batteries 710 and eight sheet batteries 660.

Note that the two sheet batteries 660 that constitute the sheet pair 650b are sheet batteries 660b and 660c as shown in Figs. 19 and 20. Further, the two sheet batteries 660 that constitute the sheet pair 650d are sheet batteries 660d and 660e. The two sheet batteries 660 that constitute the sheet pair 650f are sheet batteries 660f and 660g. The two sheet batteries 660 that constitute the sheet pair 650h are sheet batteries 660h and 660i.

The sheet battery 710a has the same structure as shown in Fig. 18. The sheet battery 710j has a structure that is the inverse of the structure shown in Fig. 18. The sheet pairs 650d and 650h have the same structure as shown in Figs. 19 and 20. The sheet pairs 650b and 650f have a structure that is the inverse of the structure shown in Figs. 19 and 20.

Thus, in the sheet battery 710j and the sheet pairs 650b and 650f, tab parts 732j and 632 are placed at the -X side edge. The tab parts 732j and 632 of the sheet battery 710j and the sheet pairs 650b and 650f overlap each other on the X-Y plane. In the sheet battery 710a and the sheet pairs 650d and 650g, tab parts 732a and 632 are placed at the -X side edge. The tab parts 732a and 632 of the sheet battery 710a and the sheet pairs 650d and 650g overlap each other on the X-Y plane.

As described in the first and second embodiments, the second electrodes can be connected by using the conductive bonding agent having a thickness corresponding to the total thickness of two sheet batteries (not shown in Fig. 21). For example, in the tab part at the +X side edge, the second electrode 17 of the sheet battery 710a and the second electrode 87 of the sheet pair 650d are placed face-to-face with each other and connected.

Likewise, in the tab part at the +X side edge, the second electrode 67 of the sheet pair 650d and the second electrode 87 of the sheet pair 650h are placed face-to-face with each other and connected. Further, in the tab part at the -X side edge, the second electrode 87 of the sheet pair 650b and the second electrode 67 of the sheet pair 650f are placed face-to-face with each other and connected. Likewise, in the tab part at the -X side edge, the second electrode 17 of the sheet battery 710j and the second electrode 87 of the sheet pair 650f are placed face-to-face with each other and connected. A conductive bonding agent is used for connection of the second electrodes 17 in the tag parts as described in the first and second embodiments.

In this manner, the same effects as in the first and second embodiments are obtained. Further, an insulating material is not needed in this embodiment, which allows further reduction of the number of parts. It is thereby possible to further improve productivity. In addition, because a double-sided battery sheet is used, it is possible to further increase the battery capacity.

The laminated battery 6 may be folded as described in the first embodiment. Further, the peripheral areas of the sheet batteries 660 and 710 may serve as joint regions and joined together by welding or the like.

In the third embodiment, the uppermost and lower most sheet batteries of the laminated battery 6 in the thickness direction may be single-sided battery sheets, and sheet batteries between them may be double-sided battery sheets. Further, the number of sheet batteries included in the laminated battery 6 is four or more. The laminated battery 6 at least includes two sheet batteries 710 and two sheet batteries 660.

### Other Embodiments

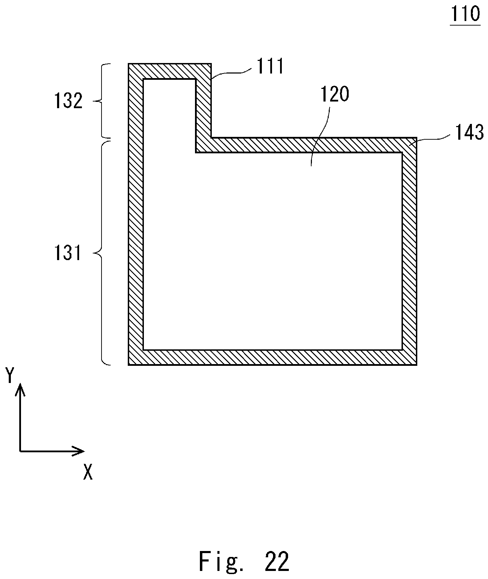

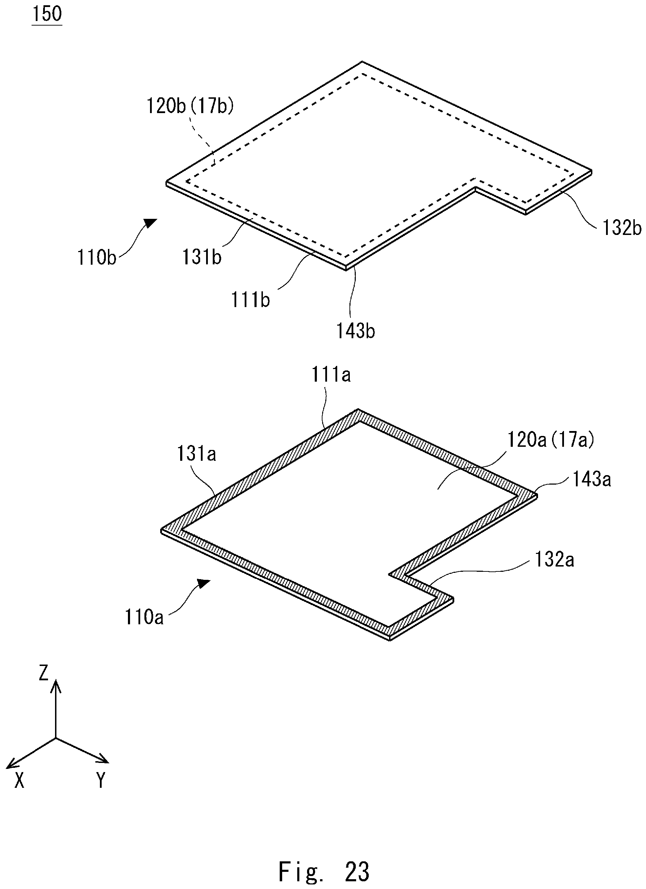

In the first and second embodiments, a position to form an insulating material is not limited to the proximity to a tab part. For example, an insulating material may be formed on the entire periphery of a base material. Figs. 22 and 23 show an example where an insulating material is formed on the entire periphery of a base material.

As shown in Figs. 22 and 23, insulating materials 143a and 143b may be formed on the entire periphery of the sheet batteries 110a and 110b, respectively. Specifically, the insulating material 143a is formed continuously on the entire periphery of the sheet battery 110a and surrounds the laminate 120a when the XY plane is viewed from above. In the peripheral part of the base material 111a, the insulating material 143a is on the uppermost surface, and in the central part, the laminate 120a is on the uppermost surface. In this structure also, the insulating material 143a is interposed between the laminate 120a in the tab part 132a and the base material 111b. This prevents short-circuit between electrodes. Further, the insulating material 143b is interposed between the laminate 120b in the tab part 132b and the base material 111a. This prevents short-circuit between electrodes.

In this embodiment, the insulating material 143 is formed on the entire periphery of the sheet battery 110. This more reliably prevents short-circuit. Note that the structure of the insulating material 143 is not limited to the above-described structure. The insulating material 143 may have the minimum necessary structure as shown in the first and second embodiments or may be formed continuously on the entire periphery as shown in Figs. 22 and 23, as long as it can prevent short-circuit between electrodes. The insulating material 143 may have another structure as a matter of course. Further, the insulating material 143 may be placed on the entire periphery of the sheet battery 110 in some part of the laminated battery, and the insulating material 143 may be placed only on a part of the periphery of the sheet battery 110 in another part of the laminated battery. The insulating material on the entire periphery as shown in Figs. 22 and 23 may be used also in the second and third embodiments.

In the sheet battery, a position to place the tab part is not limited to the above-described position. In the first and second embodiments, the tab parts are placed at positions not overlapping each other. In the third embodiment, the tab parts are placed at positions overlapping each other in the sheet pair.

Further, although an example in which the second electrode 17 acts as a positive electrode and the base material 11 (first electrode) acts as a negative electrode is described above, the second electrode 17 may act as a negative electrode the base material may act as a positive electrode. Specifically, when the first electrode (base material) is a positive electrode, a negative electrode, which is the second electrode, is formed on the surface of the base material, and when the first electrode (base material) is a negative electrode, a positive electrode, which is the second electrode, is formed on the surface of the base material

### Reference Signs List

- 1: LAMINATED BATTERY
- 3: LAMINATED BATTERY
- 6: LAMINATED BATTERY
- 10: SHEET BATTERY
- 11: BASE MATERIAL (FIRST ELECTRODE)
- 13: N-TYPE OXIDE SEMICONDUCTOR LAYER
- 14: CHARGING LAYER
- 16: P-TYPE OXIDE SEMICONDUCTOR LAYER
- 17: SECOND ELECTRODE
- 20: LAMINATE
- 31: RECTANGULAR PART
- 32: TAB PART
- 120: LAMINATE
- 220: LAMINATE
- 320: LAMINATE
- 143: INSULATING MATERIAL
- 45: CONDUCTIVE BONDING AGENT
- 345: CONDUCTIVE BONDING AGENT
- 110: SHEET BATTERY (TYPE I)
- 210: SHEET BATTERY (TYPE II)
- 310: SHEET BATTERY (TYPE III)
- 660: SHEET BATTERY (TYPE IV)
- 710: SHEET BATTERY (TYPE V)
- 150: SHEET PAIR
- 250: SHEET PAIR
- 350: SHEET PAIR
- 650: SHEET PAIR

## Claims

1. A secondary battery (1) in which a plurality of sheet batteries (10) are laminated, comprising:
a first sheet battery (110a), a second sheet battery (110b), a third sheet battery (210c) and a fourth sheet battery (210d), each including a first electrode (11) on a front side surface and a second electrode (17) on a back side surface, wherein
when viewed from above in a state where the first sheet battery (110a), the second sheet battery (110b), the third sheet battery (210c) and the fourth sheet battery (210d) are laminated,
the first sheet battery (110a) includes a first tab part (132a) placed so as to project outward of the second sheet battery (110b), and the second sheet battery (110b) includes a second tab part (132b) placed so as to project outward of the first sheet battery (110a) in a state where the second electrode (17a) of the first sheet battery (110a) and the second electrode (17b) of the second sheet battery (110b) are placed face-to-face to each other,
the third sheet battery (210c) includes a third tab part (232c) placed so as to project outward of the fourth sheet battery (210d), and the fourth sheet battery (210d) includes a fourth tab part (232d) placed so as to project outward of the third sheet battery (210c) in a state where the second electrode (17c) of the third sheet battery (210c) and the second electrode (17d) of the fourth sheet battery (210d) are placed face-to-face to each other,
the first tab part (132a) and the fourth tab part (232d) overlap each other so that the second electrode (17a) on the surface of the first tab part (132a) and the second electrode (17d) on the surface of the fourth tab part (232d) are placed face-to-face to each other;
and
the second tab part and the third tab part are placed so as to overlap each other when viewed from above in a state where the first to fourth sheet batteries are laminated.

2. The laminated secondary battery (1) according to Claim 1, wherein the second electrode (17a) on the surface of the first tab part (132a) and the second electrode (17d) on the surface of the fourth tab part (232d) are connected through a conductive bonding agent (45ad).

3. The laminated secondary battery (1) according to Claim 2, wherein a thickness of the conductive bonding agent (45) is equal to a total thickness of the second sheet battery (110b) and the third sheet battery (210c).

4. The laminated secondary battery (1) according to any one of Claims 1 to 3, wherein the first to fourth sheet batteries (110a, 110b, 210c, 210d) are laminated and folded without folding the first tab part (132a), the second tab part (132b), the third tab part (232c) and the fourth tab part (232d).

5. The laminated secondary battery (1) according to any one of Claims 1 to 4, wherein
each of the first sheet battery (110a), the second sheet battery (110b), the third sheet battery (210c) and the fourth sheet battery (210d) includes a base material serving as the first electrode, and
peripheral parts of the base materials of the first sheet battery (110a), the second sheet battery (110b), the third sheet battery (210c) and the fourth sheet battery (210d) are bonded together.

6. The laminated secondary battery (1) according to any one of the preceding claims, further comprising:
a fifth sheet battery (110e) and a sixth sheet battery (110f), each including a first electrode on a front side surface and a second electrode on a back side surface, wherein
when viewed from above in a state where the first to sixth sheet batteries are laminated, the fifth sheet battery (110e) includes a fifth tab part (132e) placed so as to project outward of the sixth sheet battery (110f), and the sixth sheet battery (110f) includes a sixth tab part (132f) placed so as to project outward of the fifth sheet battery (110e) in a state where the second electrode of the fifth sheet battery (110e) and the second electrode of the sixth sheet battery (110f) are placed face-to-face to each other, and
the third tab part (232c) and the sixth tab part (132f) overlap each other so that the second electrode on the surface of the third tab part (232c) and the second electrode on the surface of the sixth tab part (110f) are placed face-to-face to each other and connected.

7. The laminated secondary battery (1) according to Claim 6, wherein the second electrode on the surface of the third tab part (232c) and the second electrode on the surface of the sixth tab part (110f) are connected through a conductive bonding agent (45cf).

8. The laminated secondary battery (1) according to any one of Claims 1 to 5, wherein the first electrode of the second sheet battery (110b) and the first electrode of the third sheet battery (232c) are placed face-to-face to each other and connected.

9. The laminated secondary battery (1) according to Claim 8, wherein
a first insulating material (143a) is formed on the first sheet battery (110a),
a second insulating material (143b) is formed on the second sheet battery (110b),
a third insulating material is formed on the third sheet battery (210c),
a fourth insulating material is formed on the fourth sheet battery (210d),
the first insulating material (143a) is formed in close proximity to the second tab part (132b),
the second insulating material (143b) is formed in close proximity to the first tab part (132a),
the third insulating material is formed in close proximity to the fourth tab part (232d), and
the fourth insulating material is formed in close proximity to the third tab part (232c).

10. The laminated secondary battery (1) according to any one of Claims 1 to 9, wherein
the first to fourth sheet batteries (110a, 110b, 210c, 210d) include rectangular parts (31) placed so as to overlap each other when viewed from above in a state where the first to fourth sheet batteries (110a, 110b, 210c, 210d) are laminated, and
the first to fourth tab parts (132a, 132b, 232c, 232d) project outward from one side of the rectangular parts (31).

11. The laminated secondary battery (1) according to any one of Claims 1 to 9, wherein
the first to fourth sheet batteries (110a, 110b, 210c, 210d) include rectangular parts (31) placed so as to overlap each other when viewed from above in a state where the first to fourth sheet batteries (110a, 110b, 210c, 210d) are laminated,
the first tab part (132a) and the fourth tab part (232d) project outward from a first side of the rectangular parts, and
the second tab part (132b) and the third tab part (232c) project outward from a second side opposed to the first side.

12. The laminated secondary battery (1) according to any one of Claims 1 to 7 wherein
each of the first to fourth sheet batteries (110a, 110b, 210c, 210d) includes a base material serving as the first electrode (11),
the second electrode (17) is formed on both surfaces of the base material, and
the second electrode of the second sheet battery (110b) and the second electrode of the third sheet battery (210c) are placed face-to-face to each other and connected.

## Patentansprüche

1. Sekundärbatterie (1), in der eine Vielzahl von Blattbatterien (10) laminiert sind, umfassend:
eine erste Blattbatterie (110a), eine zweite Blattbatterie (110b), eine dritte Blattbatterie (210c) und eine vierte Blattbatterie (210d), die jeweils eine erste Elektrode (11) auf einer vorderen Seitenfläche und eine zweite Elektrode (17) auf einer hinteren Seitenfläche enthalten, wobei
von oben betrachtet in einem Zustand, in dem die erste Blattbatterie (110a), die zweite Blattbatterie (110b), die dritte Blattbatterie (210c) und die vierte Blattbatterie (210d) laminiert sind,
die erste Blattbatterie (110a) ein erstes Laschenteil (132a) enthält, das angeordnet ist, um von der zweiten Blattbatterie (110b) nach außen vorzustehen, und die zweite Blattbatterie (110b) ein zweites Laschenteil (132b) enthält, das angeordnet ist, um von der ersten Blattbatterie (110a) nach außen vorzustehen, in einem Zustand, in dem die zweite Elektrode (17a) der ersten Blattbatterie (110a) und die zweite Elektrode (17b) der zweiten Blattbatterie (110b) einander gegenüberliegend angeordnet sind,
die dritte Blattbatterie (210c) ein drittes Laschenteil (232c) enthält, das angeordnet ist, um von der vierten Blattbatterie (210d) nach außen vorzustehen, und die vierte Blattbatterie (210d) ein viertes Laschenteil (232d) enthält, das angeordnet ist, um von der dritten Blattbatterie (210c) nach außen vorzustehen, in einem Zustand, in dem die zweite Elektrode (17c) der dritten Blattbatterie (210c) und die zweite Elektrode (17d) der vierten Blattbatterie (210d) einander gegenüberliegend angeordnet sind,
das erste Laschenteil (132a) und das vierte Laschenteil (232d) einander überlappen, sodass die zweite Elektrode (17a) auf der Oberfläche des ersten Laschenteils (132a) und die zweite Elektrode (17d) auf der Oberfläche des vierten Laschenteils (232d) einander gegenüberliegend angeordnet sind;
und
das zweite Laschenteil und das dritte Laschenteil angeordnet sind, um einander zu überlappen, wenn sie von oben in einem Zustand betrachtet werden, in dem die erste bis vierte Blattbatterie laminiert sind.

2. Laminierte Sekundärbatterie (1) nach Anspruch 1, wobei die zweite Elektrode (17a) auf der Oberfläche des ersten Laschenteils (132a) und die zweite Elektrode (17d) auf der Oberfläche des vierten Laschenteils (232d) durch ein leitfähiges Bindemittel (45ad) verbunden sind.

3. Laminierte Sekundärbatterie (1) nach Anspruch 2, wobei eine Dicke des leitfähigen Bindemittels (45) gleich einer Gesamtdicke der zweiten Blattbatterie (110b) und der dritten Blattbatterie (210c) ist.

4. Laminierte Sekundärbatterie (1) nach einem der Ansprüche 1 bis 3, wobei die erste bis vierte Blattbatterie (110a, 110b, 210c, 210d) laminiert und gefaltet sind, ohne das erste Laschenteil (132a), das zweite Laschenteil (132b), das dritte Laschenteil (232c) und das vierte Laschenteil (232d) zu falten.

5. Laminierte Sekundärbatterie (1) nach einem der Ansprüche 1 bis 4, wobei
jede der ersten Blattbatterie (110a), der zweiten Blattbatterie (110b), der dritten Blattbatterie (210c) und der vierten Blattbatterie (210d) ein Basismaterial enthält, das als erste Elektrode dient, und
Randteile der Basismaterialien der ersten Blattbatterie (110a), der zweiten Blattbatterie (110b), der dritten Blattbatterie (210c) und der vierten Blattbatterie (210d) miteinander verbunden sind.

6. Laminierte Sekundärbatterie (1) nach einem der vorstehenden Ansprüche, ferner umfassend:
eine fünfte Blattbatterie (110e) und eine sechste Blattbatterie (110f), die jeweils eine erste Elektrode auf einer vorderen Seitenfläche und eine zweite Elektrode auf einer hinteren Seitenfläche enthalten, wobei
von oben betrachtet in einem Zustand, in dem die erste bis sechste Blattbatterie laminiert sind, die fünfte Blattbatterie (110e) ein fünftes Laschenteil (132e) enthält, das angeordnet ist, um von der sechsten Blattbatterie (110f) nach außen vorzustehen, und die sechste Blattbatterie (110f) ein sechstes Laschenteil (132f) enthält, das angeordnet ist, um von der fünften Blattbatterie (110e) nach außen vorzustehen, in einem Zustand, in dem die zweite Elektrode der fünften Blattbatterie (110e) und die zweite Elektrode der sechsten Blattbatterie (110f) einander gegenüberliegend angeordnet sind, und
das dritte Laschenteil (232c) und das sechste Laschenteil (132f) einander überlappen, sodass die zweite Elektrode auf der Oberfläche des dritten Laschenteils (232c) und die zweite Elektrode auf der Oberfläche des sechsten Laschenteils (110f) einander gegenüberliegend angeordnet und verbunden sind.

7. Laminierte Sekundärbatterie (1) nach Anspruch 6, wobei die zweite Elektrode auf der Oberfläche des dritten Laschenteils (232c) und die zweite Elektrode auf der Oberfläche des sechsten Laschenteils (110f) durch ein leitfähiges Bindemittel (45cf) verbunden sind.

8. Laminierte Sekundärbatterie (1) nach einem der Ansprüche 1 bis 5, wobei die erste Elektrode der zweiten Blattbatterie (110b) und die erste Elektrode der dritten Blattbatterie (232c) einander gegenüberliegend angeordnet und verbunden sind.

9. Laminierte Sekundärbatterie (1) nach Anspruch 8, wobei
ein erstes Isoliermaterial (143a) auf der ersten Blattbatterie (110a) ausgebildet ist,
ein zweites Isoliermaterial (143b) auf der zweiten Blattbatterie (110b) ausgebildet ist,
ein drittes Isoliermaterial auf der dritten Blattbatterie (210c) ausgebildet ist,
ein viertes Isoliermaterial auf der vierten Blattbatterie (210d) ausgebildet ist,
das erste Isoliermaterial (143a) in unmittelbarer Nähe des zweiten Laschenteils (132b) ausgebildet ist,
das zweite Isoliermaterial (143b) in unmittelbarer Nähe des ersten Laschenteils (132a) ausgebildet ist,
das dritte Isoliermaterial in unmittelbarer Nähe des vierten Laschenteils (232d) ausgebildet ist, und
das vierte Isoliermaterial in unmittelbarer Nähe des dritten Laschenteils (232c) ausgebildet ist.

10. Laminierte Sekundärbatterie (1) nach einem der Ansprüche 1 bis 9, wobei
die erste bis vierte Blattbatterie (110a, 110b, 210c, 210d) rechteckige Teile (31) enthalten, die angeordnet sind, um einander zu überlappen, wenn sie von oben in einem Zustand betrachtet werden, in dem die erste bis vierte Blattbatterie (110a, 110b, 210c, 210d) laminiert sind, und
die ersten bis vierten Laschenteile (132a, 132b, 232c, 232d) von einer Seite der rechteckigen Teile (31) nach außen vorstehen.

11. Laminierte Sekundärbatterie (1) nach einem der Ansprüche 1 bis 9, wobei
die erste bis vierte Blattbatterie (110a, 110b, 210c, 210d) rechteckige Teile (31) enthalten, die angeordnet sind, um einander zu überlappen, wenn sie von oben in einem Zustand betrachtet werden, in dem die erste bis vierte Blattbatterie (110a, 110b, 210c, 210d) laminiert sind,
das erste Laschenteil (132a) und das vierte Laschenteil (232d) von einer ersten Seite der rechteckigen Teile nach außen vorstehen und
das zweite Laschenteil (132b) und das dritte Laschenteil (232c) von einer der ersten Seite gegenüberliegenden zweiten Seite nach außen vorstehen.

12. Laminierte Sekundärbatterie (1) nach einem der Ansprüche 1 bis 7, wobei
jede der ersten bis vierten Blattbatterien (110a, 110b, 210c, 210d) ein Basismaterial enthält, das als erste Elektrode (11) dient,
die zweite Elektrode (17) auf beiden Oberflächen des Basismaterials ausgebildet ist und
die zweite Elektrode der zweiten Blattbatterie (110b) und die zweite Elektrode der dritten Blattbatterie (210c) einander gegenüberliegend angeordnet und verbunden sind.

## Revendications

1. Batterie secondaire (1) dans laquelle une pluralité de batteries en feuille (10) sont stratifiées, comprenant :
une première batterie en feuille (110a), une deuxième batterie en feuille (110b), une troisième batterie en feuille (210c) et une quatrième batterie en feuille (210d), comprenant chacune une première électrode (11) sur une surface latérale avant et une seconde électrode (17) sur une surface latérale arrière, dans laquelle
lorsqu'elle est vue de dessus dans un état où la première batterie en feuille (110a), la deuxième batterie en feuille (110b), la troisième batterie en feuille (210c) et la quatrième batterie en feuille (210d) sont stratifiées,
la première batterie en feuille (110a) comprend une première partie languette (132a) placée de manière à faire saillie vers l'extérieur de la deuxième batterie en feuille (110b), et la deuxième batterie en feuille (110b) comprend une deuxième partie languette (132b) placée de manière à faire saillie vers l'extérieur de la première batterie en feuille (110a) dans un état où la seconde électrode (17a) de la première batterie en feuille (110a) et la seconde électrode (17b) de la deuxième batterie en feuille (110b) sont placées face à face,
la troisième batterie en feuille (210c) comprend une troisième partie languette (232c) placée de manière à faire saillie vers l'extérieur de la quatrième batterie en feuille (210d), et la quatrième batterie en feuille (210d) comprend une quatrième partie languette (232d) placée de manière à faire saillie vers l'extérieur de la troisième batterie en feuille (210c) dans un état où la seconde électrode (17c) de la troisième batterie en feuille (210c) et la seconde électrode (17d) de la quatrième batterie en feuille (210d) sont placées face à face,
la première partie languette (132a) et la quatrième partie languette (232d) se chevauchent de sorte que la seconde électrode (17a) sur la surface de la première partie languette (132a) et la seconde électrode (17d) sur la surface de la quatrième partie languette (232d) sont placées face à face ;
et
la deuxième partie languette et la troisième partie languette sont placées de manière à se chevaucher l'une l'autre lorsqu'elles sont vues de dessus dans un état où les première à quatrième batteries en feuille sont stratifiées.

2. Batterie secondaire stratifiée (1) selon la revendication 1, dans laquelle la seconde électrode (17a) sur la surface de la première partie languette (132a) et la seconde électrode (17d) sur la surface de la quatrième partie languette (232d) sont reliées par l'intermédiaire d'un agent de liaison conducteur (45ad).

3. Batterie secondaire stratifiée (1) selon la revendication 2, dans laquelle une épaisseur de l'agent de liaison conducteur (45) est égale à une épaisseur totale de la deuxième batterie en feuille (110b) et de la troisième batterie en feuille (210c).

4. Batterie secondaire stratifiée (1) selon l'une quelconque des revendications 1 à 3, dans laquelle les première à quatrième batteries en feuille (110a, 110b, 210c, 210d) sont stratifiées et pliées sans plier la première partie languette (132a), la deuxième partie languette (132b), la troisième partie languette (232c) et la quatrième partie languette (232d) .

5. Batterie secondaire stratifiée (1) selon l'une quelconque des revendications 1 à 4, dans laquelle
chacune de la première batterie en feuille (110a), de la deuxième batterie en feuille (110b), de la troisième batterie en feuille (210c) et de la quatrième batterie en feuille (210d) comprend un matériau de base servant de première électrode, et
les parties périphériques des matériaux de base de la première batterie en feuille (110a), de la deuxième batterie en feuille (110b), de la troisième batterie en feuille (210c) et de la quatrième batterie en feuille (210d) sont liées ensemble.

6. Batterie secondaire stratifiée (1) selon l'une quelconque des revendications précédentes, comprenant en outre :
une cinquième batterie en feuille (110e) et une sixième batterie en feuille (110f), chacune comprenant une première électrode sur une surface latérale avant et une seconde électrode sur une surface latérale arrière, dans laquelle lorsqu'elle est vue de dessus dans un état où les première à sixième batteries en feuille sont stratifiées, la cinquième batterie en feuille (110e) comprend une cinquième partie languette (132e) placée de manière à faire saillie vers l'extérieur de la sixième batterie en feuille (110f), et la sixième batterie en feuille (110f) comprend une sixième partie languette (132f) placée de manière à faire saillie vers l'extérieur de la cinquième batterie en feuille (110e) dans un état où la seconde électrode de la cinquième batterie en feuille (110e) et la seconde électrode de la sixième batterie en feuille (110f) sont placées face à face, et
la troisième partie languette (232c) et la sixième partie languette (132f) se chevauchent de sorte que la seconde électrode sur la surface de la troisième partie languette (232c) et la seconde électrode sur la surface de la sixième partie languette (110f) sont placées face à face et reliées.

7. Batterie secondaire stratifiée (1) selon la revendication 6, dans laquelle la seconde électrode sur la surface de la troisième partie languette (232c) et la seconde électrode sur la surface de la sixième partie languette (110f) sont reliées par l'intermédiaire d'un agent de liaison conducteur (45cf).

8. Batterie secondaire stratifiée (1) selon l'une quelconque des revendications 1 à 5, dans laquelle la première électrode de la deuxième batterie en feuille (110b) et la première électrode de la troisième batterie en feuille (232c) sont placées face à face et reliées.

9. Batterie secondaire stratifiée (1) selon la revendication 8, dans laquelle
un premier matériau isolant (143a) est formé sur la première batterie en feuille (110a),
un deuxième matériau isolant (143b) est formé sur la deuxième batterie en feuille (110b),
un troisième matériau isolant est formé sur la troisième batterie en feuille (210c),
un quatrième matériau isolant est formé sur la quatrième batterie en feuille (210d),
le premier matériau isolant (143a) est formé à proximité immédiate de la deuxième partie languette (132b),
le deuxième matériau isolant (143b) est formé à proximité immédiate de la première partie languette (132a),
le troisième matériau isolant est formé à proximité immédiate de la quatrième partie languette (232d), et
le quatrième matériau isolant est formé à proximité immédiate de la troisième partie languette (232c).

10. Batterie secondaire stratifiée (1) selon l'une quelconque des revendications 1 à 9, dans laquelle
les première à quatrième batteries en feuille (110a, 110b, 210c, 210d) comprennent des parties rectangulaires (31) placées de manière à se chevaucher les unes les autres lorsqu'elles sont vues de dessus dans un état où les première à quatrième batteries en feuille (110a, 110b, 210c, 210d) sont stratifiées, et
les première à quatrième parties languettes (132a, 132b, 232c, 232d) font saillie vers l'extérieur à partir d'un côté des parties rectangulaires (31).

11. Batterie secondaire stratifiée (1) selon l'une quelconque des revendications 1 à 9, dans laquelle
les première à quatrième batteries en feuille (110a, 110b, 210c, 210d) comprennent des parties rectangulaires (31) placées de manière à se chevaucher les unes les autres lorsqu'elles sont vues de dessus dans un état où les première à quatrième batteries en feuille (110a, 110b, 210c, 210d) sont stratifiées,
la première partie languette (132a) et la quatrième partie languette (232d) font saillie vers l'extérieur à partir d'un premier côté des parties rectangulaires, et
la deuxième partie languette (132b) et la troisième partie languette (232c) font saillie vers l'extérieur à partir d'un second côté opposé au premier côté.

12. Batterie secondaire stratifiée (1) selon l'une quelconque des revendications 1 à 7 dans laquelle
chacune des première à quatrième batteries en feuille (110a, 110b, 210c, 210d) comprend un matériau de base servant de première électrode (11),
la seconde électrode (17) est formée sur les deux surfaces du matériau de base, et
la seconde électrode de la deuxième batterie en feuille (110b) et la seconde électrode de la troisième batterie en feuille (210c) sont placées face à face et reliées.
